# FASCICULE DE BREVET EUROPEEN

(11) **EP 0 891 629 B1**
(45) Date de publication et mention de la délivrance du brevet: **31.08.2005**
(21) Numéro de dépôt: 97919463.6
(22) Date de dépôt: 02.04.1997
(51) Int. Cl.: H01L 21/00

(54) **SYSTEME D'ACCOUPLEMENT POUR UN TRANSFERT CONFINE D'UN OBJET PLAT D'UNE BOITE DE CONFINEMENT VERS UNE UNITE DE TRAITEMENT DE L'OBJET**
KUPPLUNGSANORDNUNG FÜR DIE GESCHLOSSENE ÜBERTRAGUNG VON EINEM FLACHEN SUBSTRAT VON EINEM GESCHLOSSENEN BEHÄLTER ZU EINER BEHANDLUNGSEINRICHTUNG
COUPLING SYSTEM FOR THE TRANSFER OF A CONFINED PLANAR OBJECT FROM A CONTAINMENT POD TO AN OBJECT PROCESSING UNIT

(30) Priorité: 03.04.1996 FR 9604170
(43) Date de publication de la demande: 20.01.1999
(73) Titulaire: COMMISSARIAT A L'ENERGIE ATOMIQUE, 75015 Paris (FR)
(72) Inventeur: DOCHE, Claude, F-38640 Claix (FR)
(74) Mandataire: Poulin, Gérard
(86) Numéro de dépôt international: PCT/FR1997/000588
(87) Numéro de publication internationale: WO 1997/038440

(56) Documents cités:
- EP-A- 0 582 018
- EP-A- 0 589 812
- FR-A- 2 697 000
- GB-A- 2 249 145
- PATENT ABSTRACTS OF JAPAN vol. 7, no. 178 (E-191) [1323] , 6 Août 1983 & JP 58 084439 A (HITACHI), 20 Mai 1983,

## Description

### Domaine technique

La présente invention concerne un système d'accouplement pour un transfert confiné d'un objet plat d'une boîte de confinement vers une unité de traitement de l'objet.

Un tel système peut être utilisé en particulier pour le transfert de plaquettes de silicium disposées individuellement dans des boîtes de confinement à atmosphère contrôlée, vers des réacteurs tels que des réacteurs de dépôt chimique en phase vapeur ou des réacteurs de gravure ou de dépôt activé par plasma, par exemple.

On entend par boîte de confinement à atmosphère contrôlée une boîte dont le milieu intérieur présente une composition, une propreté, une pureté et/ou une pression déterminées.

### Etat de la technique antérieure

Le transfert des objets plats, et en particulier des plaquettes de silicium se fait généralement en salle blanche directement d'un panier à étages contenant les objets plats, vers l'unité de traitement.

Les coûts et les difficultés techniques liés à la réalisation de salles blanches de volume important et correspondant à une classe de grande propreté conduisent cependant à l'utilisation d'enceintes de confinement de taille réduite pouvant contenir les objets pour lesquels un environnement propre est requis.

Ces enceintes de confinement, décrites plus en détail ci-après, présentent aussi l'avantage de pouvoir maintenir autour des objets une atmosphère pure. On entend par atmosphère pure une atmosphère ne contenant pas de produits contaminants chimiques. Il s'agit par exemple d'atmosphères d'azote N₂ ou de gaz rare tel que l'argon par exemple.

On distingue dans la suite du texte une atmosphère pure telle que définie ici, et une atmosphère propre qui se caractérise par un nombre réduit d'éléments contaminants particulaires (≥0,3 µm) par unité de volume.

Un premier type d'enceinte de confinement est désigné par l'acronyme SMIF (Standardized Mechanical Interface). Il s'agit de boîtes avec un couvercle en forme de cloche reposant sur un plateau de base. Un ajustage étanche est prévu entre le couvercle et le plateau de base. Ces boites contiennent également un panier dans lequel sont empilées des plaquettes de semi-conducteurs.

Ces enceintes de confinement servent à déplacer les plaquettes de leur lieu de fabrication vers une unité de traitement, ou d'une unité de traitement à une autre unité de traitement, tout en les maintenant dans une atmosphère confinée, propre et pure, telle que définie précédemment.

Une description détaillée des enceintes SMIF peut être trouvée dans les documents (1) et (2) dont les références sont indiquées à la fin de la présente description.

Pour transférer les plaquettes des enceintes SMIF vers une unité de traitement, un sas de transfert équipé d'un robot de déchargement est prévu en tête de l'unité de traitement. Un tel sas, dans lequel une atmosphère propre et éventuellement pure doit être maintenue, est indispensable pour éviter une contamination des objets plats lorsque ceux-ci sont retirés de l'enceinte de confinement. Le sas de transfert est également appelé "mini-environnement" "enclosure" ou "canopy". L'ensemble du panier et des plaquettes qu'il contient est extrait de l'enceinte de confinement à l'intérieur du sas, puis les plaquettes sont retirées une à une du panier pour être introduites dans l'unité de traitement.

Les enceintes SMIF présentent cependant un certain nombre de désavantages. Parmi ceux-ci on peut citer le fait que celles-ci ne permettent pas d'éviter une pollution mutuelle des plaquettes de silicium qui y sont stockées. Par ailleurs en raison de leur capacité fixe, de l'ordre de 25 plaquettes, ces enceintes ne sont pas adaptées à une utilisation flexible dans le cadre d'une production en flux tendu.

En raison de ces problèmes d'autres enceintes de confinement sous forme de boites individuelles ont été conçues. De telles boîtes sont décrites dans les documents (1) et (2), mais aussi dans le document (3) dont la référence est également indiquée en fin de description. Ces boîtes présentent une ouverture latérale d'introduction et d'extraction des plaquettes. Elles sont fermées de façon étanche par une porte pouvant pivoter. Pour transférer les plaquettes de semi-conducteurs vers une unité de traitement, les boîtes individuelles, tout comme les enceintes SMIF, sont placées dans un sas disposé devant une ouverture d'entrée/sortie de l'unité de traitement. L'ouverture d'entrée/sortie de l'unité de traitement est également fermée par une porte. Un exemple de boîte individuelle ainsi qu'un système d'ouverture de sa porte est également décrit dans le document (4) dont la référence est précisée à la fin de la présente description.

Lorsqu'une boîte individuelle de confinement est en place, dans le sas, devant l'ouverture de l'unité de traitement, les portes de la boîte et de l'unité de traitement peuvent être ouvertes pour transférer la plaquette.

Le sas, disposé à l'entrée des unités de traitement, constitue un équipement complexe dans lequel il est nécessaire de maintenir une atmosphère propre.

De plus, le sas de transfert doit être équipé d'un robot de transfert pour extraire les objets plats à traiter de leur boîte de confinement. Un tel équipement est visible, par exemple, sur des figures du document (2).

Des difficultés supplémentaires apparaissent lorsque les plaquettes ou les objets plats doivent être maintenus dans une atmosphère pure ou inerte, par exemple, une atmosphère d'azote. Ces difficultés sont liées, par exemple, à la nécessité de purger fréquemment le sas dont le volume intérieur est en général assez important, notamment en raison de la présence du robot de transfert. Un exemple de transfert d'objets plats en atmosphère propre est décrit dans le document (5) dont la référence est également donnée à la fin de la présente description.

Par ailleurs, les enceintes de confinement et les sas des unités de traitement ne permettent généralement pas un transfert sous vide des plaquettes.

Ainsi, un but de la présente invention est de proposer un système d'accouplement pour le transfert d'un objet plat d'une boîte de confinement vers une unité de traitement, ne présentant pas les limitations et les inconvénients évoqués ci-dessus.

Un autre but de l'invention est de proposer un tel système permettant un transfert sans rupture de l'atmosphère propre entourant les objets.

Un but est également de proposer un système autorisant un transfert dans une atmosphère pure.

Un but est encore de proposer un système permettant un transfert sous vide des objets plats.

Un but de l'invention est aussi de proposer un système qui ne nécessite pas de robot de transfert qui lui est propre, mais avec lequel il est possible d'utiliser directement un robot équipant déjà l'unité de traitement pour extraire les objets plats des boîtes de confinement.

Un autre but est de proposer un système simple, moins coûteux que les systèmes à sas et peu encombrant.

Un but est enfin de proposer un système sans sas, qui reste compatible avec un transfert direct des objets plats depuis un panier à étages tel que mentionné au début de la description.

### Exposé de l'invention

Pour atteindre les buts mentionnés ci-dessus, l'invention a plus précisément pour objet un système d'accouplement pour le transfert confiné d'un objet plat d'une boîte de confinement comportant une première ouverture latérale de transfert de l'objet plat, avec un premier obturateur, vers une unité de traitement de l'objet plat, comportant au moins une seconde ouverture de transfert de l'objet plat.

Conformément à l'invention, le dispositif comporte les caractéristiques de la revendication indépendante.

Le document GB-A-2 249 145 correspond au préambule de la revendication 1 ; la pièce d'embouchure est fixe, et aucun obturateur ne la sépare de l'unité de traitement ou de moyens de raccordement fragiles entre l'unité de traitement et la pièce d'embouchure.

Le transfert de l'objet plat de la boîte de confinement vers l'unité de traitement a lieu à travers les moyens d'accouplement étanche et est effectué par un mécanisme de déplacement de l'objet plat. Un tel mécanisme existe sur les unités de traitement sous la forme d'un robot manipulateur des objets plats.

Les moyens d'accouplement et les moyens de libération des première et seconde ouvertures, après accouplement, permettent de mettre directement en communication les milieux intérieurs de la boîte de confinement et de l'unité de traitement.

L'accouplement est étanche au milieu environnant. La propreté et la pureté de l'atmosphère dans la boîte et dans l'unité de traitement sont donc préservées.

Ainsi, le système peut fonctionner dans un environnement autre que celui d'une salle blanche sans nécessiter un sas de transfert. De plus, comme indiqué précédemment, l'absence de sas de transfert permet d'utiliser le traitement pour transférer les objets plats.

Le système d'accouplement au sens de la présente invention est compris comme un ensemble de moyens ou de mécanismes dont certains font partie de la boîte de confinement et dont d'autres sont solidaires de l'unité de traitement.

La description qui suit est donnée en se référant à une unique boîte de confinement contenant un unique objet plat à transférer. L'invention ne se limite cependant pas à ce cas. Le système de transfert peut être utilisé notamment pour le transfert d'objets plats provenant d'un empilement d'une pluralité de boîte de confinement ou de plusieurs objets plats contenus dans une unique boîte de confinement.

Lorsque la pièce d'embouchure est rétractée, la première ouverture et une ouverture des moyens d'accouplement, à l'extrémité de la pièce d'embouchure, sont fermées par les premier et deuxième obturateurs. Ceci permet d'isoler respectivement l'intérieur des moyens d'accouplement. De plus, comme un raccord relie de façon étanche la pièce d'embouchure à l'embase, l'intérieur de l'unité de traitement est également isolé du milieu environnant lorsque, dans la position rétractée de la pièce d'embouchure, l'ouverture des moyens d'accouplement est fermée par le deuxième obturateur. La boîte de confinement peut alors être déplacée par un mécanisme adapté pour la positionner devant les moyens d'accouplement.

La libération des première et deuxième ouvertures n'a lieu que lorsque la pièce d'embouchure est dans sa position déployée, en appui contre la boîte.

Pour parfaire l'étanchéité, la pièce d'embouchure peut présenter un bord d'étanchéité et chaque boîte de confinement peut présenter une plage d'appui entourant la première ouverture et apte à recevoir le bord d'étanchéité.

Le deuxième obturateur peut être réalisé, par exemple, sous la forme d'une porte pivotante.

Les moyens de libération des ouvertures des premier et deuxième obturateurs peuvent comporter un mécanisme de pivotement, relié au second obturateur, pour faire pivoter le second obturateur et la porte de la boîte de confinement entre une position d'obturation et une position d'ouverture. Dans la position d'ouverture les volumes intérieurs des boîtes de confinement, des moyens d'accouplement, et de l'unité de traitement sont mis en communication.

A cet effet, la pièce d'embouchure peut comporter, en particulier dans une paroi de fond, une dépression pour recevoir les premier et deuxième obturateurs dans leur position d'ouverture.

Il convient de noter que, contrairement aux dispositifs connus de l'art antérieur, dans lesquels les portes des boîtes de confinement sont maintenues et actionnées par un mécanisme extérieur au milieu confiné, la porte de la boîte de confinement équipée du système de l'invention est maintenue et pivotée à l'intérieur du milieu confiné.

Le deuxième obturateur est disposé dans la pièce d'embouchure sur un côté tourné vers la boîte de confinement. Un troisième obturateur, associé à la deuxième ouverture, c'est-à-dire l'ouverture existante de l'unité de traitement, est également disposé dans la pièce d'embouchure sur le côté tourné vers l'unité de traitement.

Dans une réalisation particulière des moyens d'accouplement, le troisième obturateur est une porte et l'embase présente un rebord d'étanchéité entourant la deuxième ouverture. La porte formant le troisième obturateur est alors appuyée de façon étanche contre le rebord d'étanchéité lorsque la pièce d'embouchure est dans sa position rétractée. A l'inverse, la porte est séparée du rebord d'étanchéité lorsque la pièce d'embouchure est dans sa position déployée.

Les premier et deuxième obturateurs comportent des premiers moyens de verrouillage/déverrouillage mutuel permettant de verrouiller le premier obturateur sur le deuxième obturateur.

De façon plus précise, les premiers moyens de verrouillage peuvent comporter un ou plusieurs dispositifs à baïonnette avec des pièces de verrouillage de forme complémentaire disposées respectivement sur les premier et deuxième obturateurs.

La pièce de verrouillage du deuxième obturateur est par exemple une clé.

Selon un perfectionnement, le premier obturateur peut en outre comporter des deuxièmes moyens de verrouillage/déverrouillage pour rendre le premier obturateur solidaire de la boîte de confinement, les deuxièmes moyens de verrouillage/déverrouillage étant également actionnables par la pièce formant clé du deuxième obturateur.

Le deuxième obturateur est relié au troisième obturateur au moyen de biellettes actionnables entre une position dite distale dans lequel les deuxième et troisième obturateurs sont écartés l'un de l'autre et une position dite proximale dans laquelle les deuxième et troisième obturateurs sont rapprochés l'un de l'autre.

D'autres caractéristiques et avantages de l'invention ressortiront mieux de la description qui va suivre en référence aux figures des dessins annexés donnée à titre purement illustratif.

### Brève description des figures

- les figures 1A à 1F sont des coupes schématiques simplifiées d'un mode de réalisation particulier d'un système non conforme à l'invention, illustrant son principe de fonctionnement,
- les figures 2A à 2D sont des coupes schématiques simplifiées d'un système non conforme à l'invention,
- les figures 3A à 3E sont des coupes schématiques d'une variante conforme à l'invention du système des figures 2A à 2D,
- la figure 4A est une coupe schématique d'une variante du système des figures 3A à 3E, adaptée à un transfert sous vide d'objets plats,
- la figure 4B montre, en coupe schématique, l'utilisation du système d'accouplement de la figure 4A pour un transfert d'objets plats sous vide,
- la figure 5A est une coupe d'un système de verrouillage entre une porte d'une boîte de confinement et un obturateur du système d'accouplement de l'invention. La figure 5A montre le système de verrouillage dans un état dans lequel la porte de la boîte de confinement et l'obturateur sont désolidarisés,
- la figure 5B est une coupe du système de verrouillage dans un état dans lequel la porte de la boite est accouplée au deuxième obturateur,
- la figure 6 est une vue de dessus d'une clavette de verrouillage de la porte de la figure 5 sur une boîte de confinement,
- les figures 7A à 7D sont des coupes schématiques simplifiées d'un système non conforme à l'invention,
- la figure 8 est une vue à échelle agrandie d'un moyen d'accouplement utilisable dans des systèmes de transfert conformes à l'invention,
- les figures 9A et 9B sont des coupes à échelle agrandie d'un détail du système,
- la figure 10 est une représentation simplifiée d'un système de transfert, adapté au transfert d'objets plats à partir d'un empilement d'une pluralité de boîtes de confinement.

### Description détaillée de modes de mise en oeuvre de l'invention

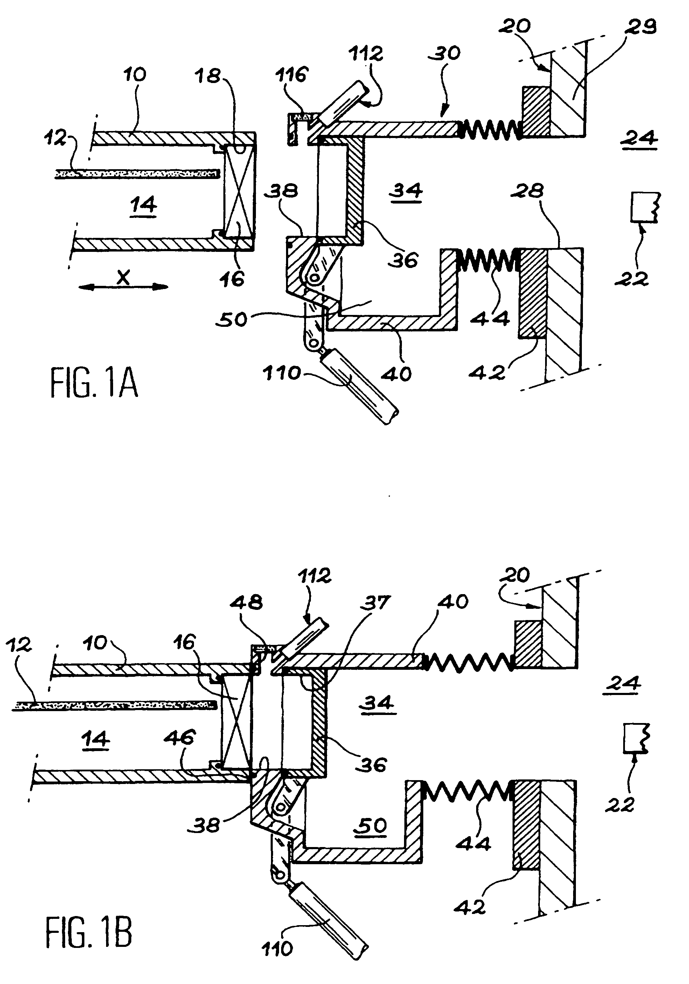

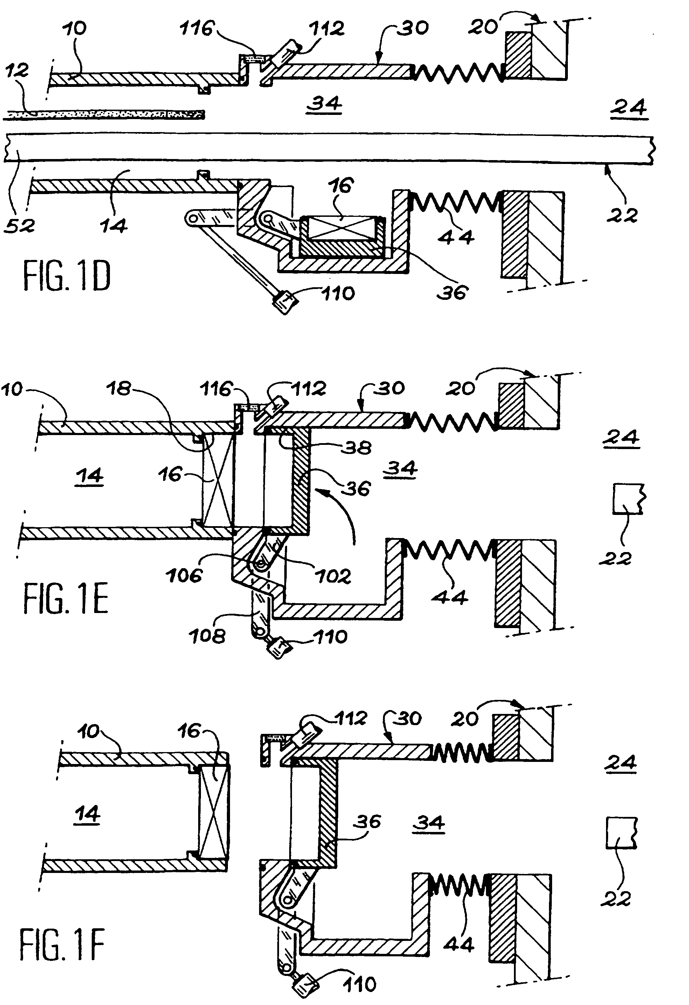

Des éléments essentiels du système de transfert et son principe de fonctionnement apparaissent sur les figures 1A à 1F qui correspondent à des étapes successives d'une opération de transfert. Pour des raisons de clarté des éléments identiques ou similaires des différentes figures portent les mêmes références.

Sur les figures 1A à 1F, une boite de confinement représentée de façon partielle, est désignée par la référence 10. Elle contient un objet plat 12 tel qu'une plaquette de semi-conducteur, par exemple. L'objet plat 12 est logé dans le volume intérieur 14 de la boite qui renferme une atmosphère propre et éventuellement pure, c'est-à-dire exempte de contaminants chimiques.

Une porte 16 sert d'obturateur pour une ouverture latérale 18 de la boîte 12 désignée aussi par première ouverture. La porte 16 ferme la première ouverture sur la figure 1A.

La référence 20 désigne une unité de traitement dans laquelle l'objet plat doit subir un traitement. Ce traitement correspond, notamment dans le cas où l'objet plat est une plaquette de silicium, à des étapes de fabrication de composants électroniques. Le traitement peut comporter des opérations de dépôt, de gravure, de mise en forme, etc..

Un robot manipulateur 22, partiellement représenté, logé dans l'unité de traitement dans sa position de repos, est prévu pour extraire l'objet plat 12 de la boîte 10 et l'amener dans l'unité de traitement.

Le volume intérieur 24 de l'unité de traitement contient également une atmosphère propre et éventuellement pure. Le volume 24 peut aussi être sous "vide", c'est-à-dire à basse pression. Ceci est le cas pour un nombre croissant d'unités de traitement.

Une ouverture 28, désignée par seconde ouverture, existant dans une paroi latérale 29 de l'unité de traitement est prévue pour le transfert d'objets.

Des moyens d'accouplement 30 de la boîte de confinement 10 et de l'unité de traitement 20, solidaires de l'unité de traitement, définissent un espace 34, étanche par rapport au milieu environnant, pour le passage de l'objet plat 12 de la boite de confinement 10 vers l'unité de traitement 20.

Un obturateur 36 est associé à une ouverture 38 d'une pièce d'embouchure 40 des moyens d'accouplement 30.

L'obturateur 36 permet d'isoler de façon étanche le volume intérieur 34 des moyens d'accouplement 30, et le volume intérieur 24 de l'unité de traitement 20, par rapport au milieu environnant, lorsque les moyens d'accouplement ne sont pas raccordés à l'ouverture 18 de la boîte de confinement 10.

Les moyens d'accouplement 30 comportent aussi une embase 42 fixée sur la paroi 29 de l'unité de traitement et entourant la deuxième ouverture 28. Un raccord étanche 44, sous la forme d'un soufflet, relie la pièce d'embouchure 40 à l'embase 42.

Un système à vérins, non représenté sur les figures 1A à 1F pour des raisons de simplification, permet de déplacer la pièce d'embouchure 40, parallèlement à une direction X de transfert des objets plats, entre une position rétractée vers l'unité de traitement (voir figure 1A), et une position dite déployée vers la boîte de confinement (voir figure 1B par exemple).

Dans une première étape d'un procédé de transfert correspondant à la figure 1A, la boîte de confinement 10 est positionnée en face de l'ouverture 38 de la pièce d'embouchure, et partant, en face de la deuxième ouverture 28 de l'unité de traitement. Des moyens de positionnement de la boîte ne sont pas visibles sur la figure.

Lors de cette première étape, la porte 16 est en position fermée sur l'ouverture 18 de la boite 10 et l'obturateur 36 est en position fermée sur l'ouverture 38 de la pièce d'embouchure 40. La pièce d'embouchure 40 est dans sa position rétractée. Les volumes intérieurs 14 et 24 de la boîte et de l'unité de traitement sont donc isolés mutuellement et par rapport à l'environnement extérieur.

Une deuxième étape, visible à la figure 1B, consiste à déplacer la pièce d'embouchure vers sa position déployée et à appliquer un bord d'étanchéité 46 de la pièce d'embouchure 40, faisant le tour de l'ouverture 38, contre une plage d'appui 48 de la boîte 10. La plage d'appui 48, est disposée sur tout le tour de l'ouverture 18 de la boite et est adaptée en dimensions au bord d'étanchéité 46 afin d'obtenir entre ces pièces un contact étanche.

Un mécanisme décrit ultérieurement permet alors de pousser la porte 16 contre l'obturateur 36 et de verrouiller ces deux pièces l'une sur l'autre afin de les rendre solidaires. Ce mécanisme n'apparaît pas sur les figures 1A à 1F.

L'examen des figures permet de constater que l'obturateur 36 présente à cet effet un évidement 37 dont la taille et la forme sont adaptées à celles de la porte 16 de la boite 10.

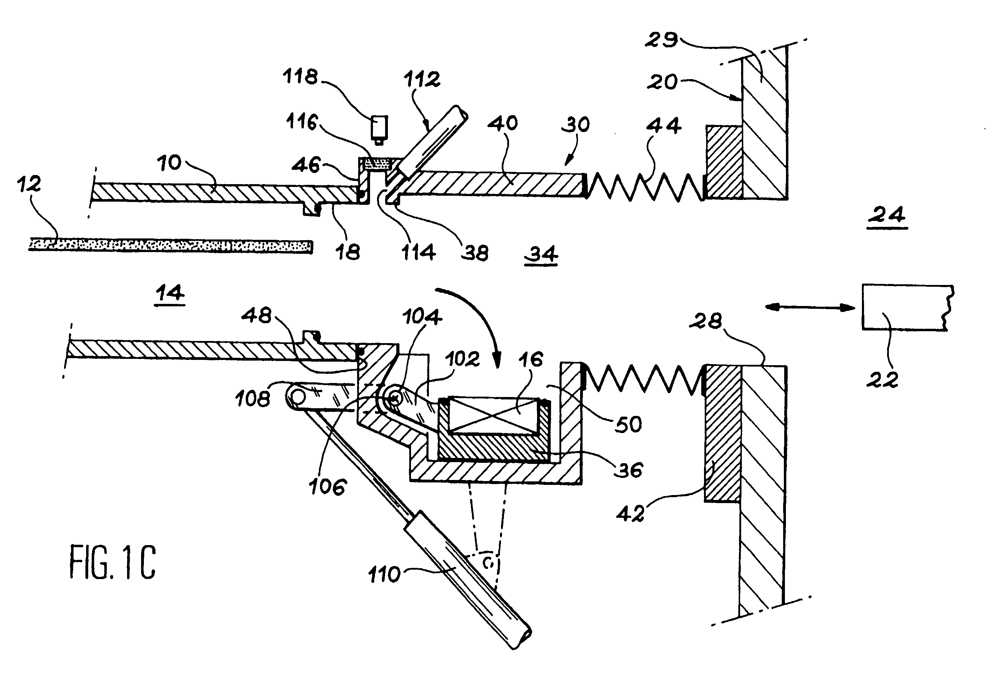

Lors d'une troisième étape représentée à la figure 1C, l'ensemble solidaire formé de la porte 16 et de l'obturateur 36 est pivoté vers une position d'ouverture, dans un logement 50 de la pièce d'embouchure 40, de façon à libérer les ouvertures 18 et 38.

Les volumes 14, 24 et 34 sont ainsi mis en communication, mais restent isolés de l'environnement extérieur.

Dans un system d'accouplement non conforme à l'invention l'obturateur 36, disposé dans la pièce d'embouchure 40, est relié par un bras 102 à un pivot 104 s'étendant selon un axe 106 perpendiculaire au plan de coupe de la figure, et perpendiculaire à la direction de transfert de l'objet plat. Un second bras d'actionnement 108 présente une extrémité solidaire du pivot 104 ainsi qu'une extrémité reliée à un vérin d'actionnement 110 solidaire de la pièce d'embouchure 40. Le pivot 104 traverse latéralement la paroi de la pièce d'embouchure depuis le bras 102 de l'obturateur qui est disposé à l'intérieur de la pièce d'embouchure, jusqu'au bras 108 disposé à l'extérieur de cette pièce, de même que le vérin 110.

Dans un system d'accouplement non conforme à l'invention l'actionnement du vérin 110 permet le pivotement de l'obturateur 36 et de la porte 16, entre une position d'obturation de l'ouverture 38 et une position libérant cette ouverture. Dans cette dernière position, l'obturateur 36 et la porte 16 sont, comme indiqué ci-dessus, reçus dans le logement 50 prévu dans le fond de la pièce d'embouchure 40. L'ensemble formé par le vérin 110, les bras 102 et 106 et le pivot 104 sont encore désignés par mécanisme de pivotement.

De façon avantageuse, la pièce d'embouchure 40 peut être équipé un système de purge 112 comprenant une buse d'injection de gaz 114 et un orifice de sortie de gaz non visible sur les figures. Le système de purge disposé au voisinage du bord d'étanchéité 46 permet d'insuffler dans les moyens d'accouplement 30, de même que dans la boîte de confinement 10 un gaz, tel que de l'azote, pour éliminer les éventuels éléments contaminants particulaires ou chimiques qui pourraient s'y trouver.

Ce système permet en particulier d'éliminer les éléments contaminants libérés par l'objet plat lui-même.

La pièce d'embouchure 40 peut également être équipée d'une fenêtre d'observation 116 en un matériau transparent. Cette fenêtre est également disposée au voisinage du bord d'étanchéité 46. Des instruments optoélectroniques 118 tels que des détecteurs de passage, des détecteurs de position, des dispositifs de télémétrie ou des lecteurs de codes optiques, sont disposés en face de la fenêtre 116.

Les instruments 118 permettent de détecter le passage de l'objet plat ou d'un doigt de préhension de l'objet, décrit plus loin, dans la pièce d'embouchure.

L'opération de transfert peut ainsi être contrôlée, et éventuellement interrompue, en cas de détection de l'objet ou du doigt de préhension dans une position incorrecte. Ceci permet d'éviter un endommagement de l'objet plat et/ou du système de transfert en cas d'incident et surtout la génération de particules dues à des frottements intempestifs.

De plus, les instruments peuvent être prévus pour la lecture d'un code de type code-barre ASCI, imprimé en bordure de l'objet plat et permettant, par exemple, son identification.

Une quatrième étape, illustrée à la figure 1D, correspond au transfert proprement dit de l'objet plat.

Le robot manipulateur 22 présente un doigt de préhension 52 qui s'avance dans la boîte 10, sous l'objet plat 12, en traversant les moyens d'accouplement 30.

Le doigt 52 est relevé pour saisir l'objet plat 12 par le dessous.

Lorsque l'objet est en appui sur le plateau 52, celui-ci est rétracté dans l'unité de traitement 20. L'objet plat 12 est alors transféré à travers les moyens d'accouplement 30 sans jamais quitter l'atmosphère propre qui l'entoure.

La figure 1E correspond à une avant-dernière étape lors de laquelle les obturateurs 16 et 36 sont à nouveau pivotés pour retrouver leur position d'obturation des ouvertures 18 et 38. Les obturateurs sont également désolidarisés l'un de l'autre par un mécanisme décrit plus loin, pour reprendre leur position correspondant à la figure 1B.

On peut noter que l'objet plat peut soit rester temporairement dans l'unité de traitement, soit être transféré à nouveau dans la même boite de confinement avant l'obturation des ouvertures 18 et 38.

Dans une dernière étape illustrée à la figure 1E, la pièce d'embouchure 40 est de nouveau rétractée vers sa position initiale en direction de l'unité de traitement.

L'ouverture 18 de la boîte de confinement et celle 38 de la pièce d'embouchure sont respectivement fermées par la porte 16 et l'obturateur 36.

Un système de transfert réalisé conformément aux figures de principe 1A à 1F est bien adapté à un transfert en atmosphère propre et pure.

Il est cependant moins adapté à un transfert sous vide. En effet, les obturateurs et en particulier le deuxième obturateur 36, de même que le soufflet 44 risquent d'être vivement sollicités par la différence de pression existant entre l'intérieur de l'unité de traitement et le milieu extérieur.

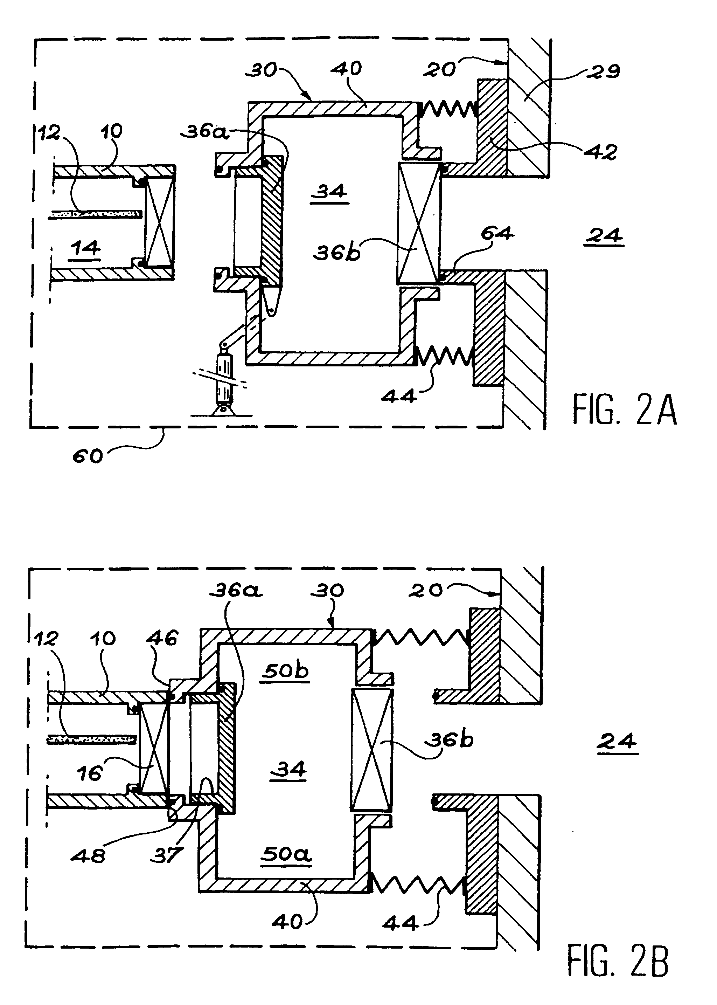

Les figures 2A à 2D représentent schématiquement le principe de fonctionnement d'une variante de réalisation du système de transfert non conforme à l'invention, mieux adaptée à un transfert sous vide.

Les éléments similaires à ceux des figures 1A à 1F portent les mêmes références et ne sont pas décrits de façon détaillée. On pourra se référer à la description qui précède.

Le volume intérieur 24 de l'unité de traitement est en permanence maintenu sous vide. Par contre, les volumes intérieurs 14 et 34 de la boite de confinement et des moyens d'accouplement ne sont mis sous vide que pour le transfert de l'objet plat.

De par leur conception, le système d'accouplement 30 et surtout les boîtes de confinement 10 ne sont généralement pas aptes à résister à la pression atmosphérique extérieure lorsque leur volume intérieur est mis sous vide.

Ainsi, on prévoit une enceinte de pompage 60 qui entoure la boîte de confinement 10 et les moyens d'accouplement 30. Cette enceinte est reliée de façon étanche à la paroi 29 de l'unité de traitement.

Le vide est établi simultanément dans l'enceinte de pompage 60, dans la boite 10 et dans les moyens d'accouplement 30, de sorte qu'il n'existe à aucun moment une différence de pression trop importante entre l'intérieur et l'extérieur de ces pièces.

De même que dans le mode de réalisation illustré par les figures 1A à 1F, la pièce d'embouchure des figures 2A à 2C comporte un obturateur 36a permettant d'obturer l'ouverture 38. Cet obturateur est toujours désigné par "deuxième obturateur". La pièce d'embouchure 40 comporte cependant, et en outre, un autre obturateur 36b, désigné par "troisième obturateur", adapté à la deuxième ouverture 28. Le troisième obturateur peut être appuyé contre un rebord 64 de l'embase 42 qui entoure l'ouverture 28 de l'unité de traitement.

Lorsque la pièce d'embouchure est dans la position rétractée représentée à la figure 2A, l'obturateur 36b ferme l'ouverture 28 de l'unité de traitement 20. Ainsi, le volume intérieur 34 des moyens d'accouplement peut être porté à pression atmosphérique sans soumettre l'obturateur 36a ou le soufflet 44 à une sollicitation importante. Les contraintes dues à la différence de pression entre l'extérieur et l'intérieur de l'unité de traitement sont entièrement supportées par l'obturateur 36b.

Avant de déplacer la pièce d'embouchure 40 vers sa position déployée visible à la figure 2B, un pompage est effectué dans l'enceinte 60, dans la boîte de confinement 10 et dans les moyens d'accouplement 30. Pour des raisons de simplification, les orifices de pompage dans ces différentes pièces et les pompes elles-mêmes ne sont pas représentés sur les figures. On rappelle également que le volume intérieur 24 de l'unité de traitement est constamment maintenu sous vide.

Dans une deuxième étape, représentée à la figure 2B, la pièce d'embouchure 40 est déplacée vers la boîte de confinement 10 et son bord d'étanchéité 46 est appliqué contre la plage d'appui 48 de la boîte.

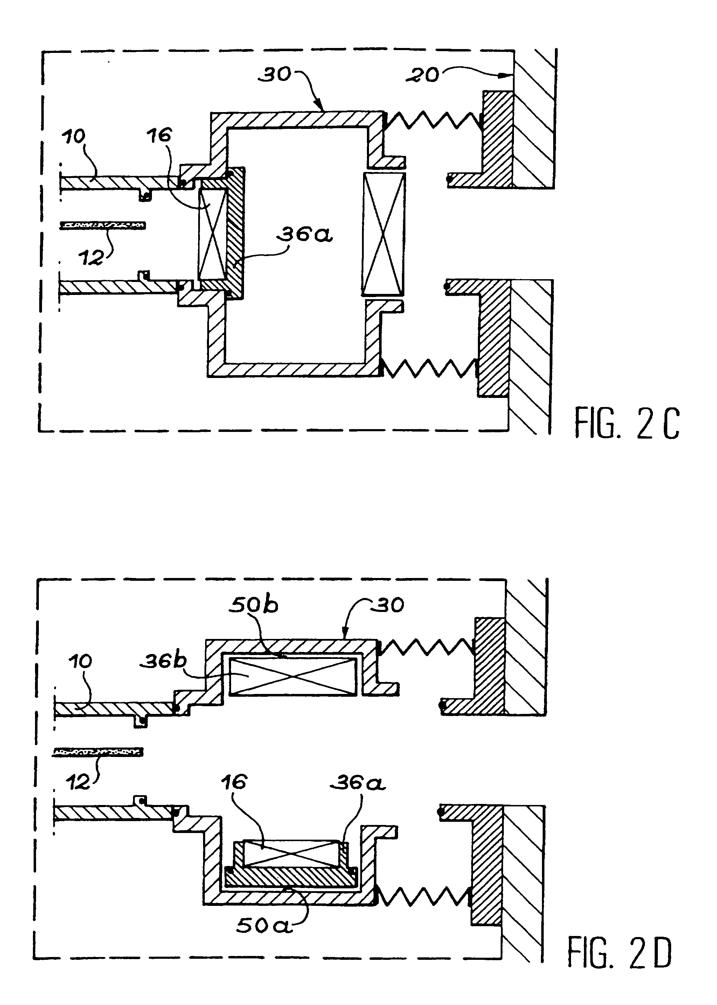

Lors d'une troisième étape, lorsque la porte 16 est poussée contre l'obturateur 36a, afin d'y être verrouillée, celle-ci peut prendre place dans un évidement 37 de la porte 36a. Cette étape est illustrée par la figure 2C.

Finalement, pour libérer un passage pour l'objet plat 12, de la boite de confinement vers l'unité de traitement ou réciproquement, l'obturateur 36a avec la porte 16, de même que l'obturateur 36b sont pivotés pour venir prendre respectivement leur place dans des logements 50a, 50b prévus à cet effet dans la pièce d'embouchure 40. Cette opération correspond à la figure 2D. Des mécanismes de pivotement des obturateurs 36a et 36b sont sensiblement identiques au mécanisme de pivotement décrit en corrélation avec la figure 1C. Ces mécanismes ne sont pas représentés de façon détaillée sur les figures 2A à 2D.

Il convient de préciser que le dispositif illustré aux figures 2A à 2D peut également convenir pour le transfert d'objets plats sous pression atmosphérique. Dans ce cas, l'enceinte de pompage 60 est superflue.

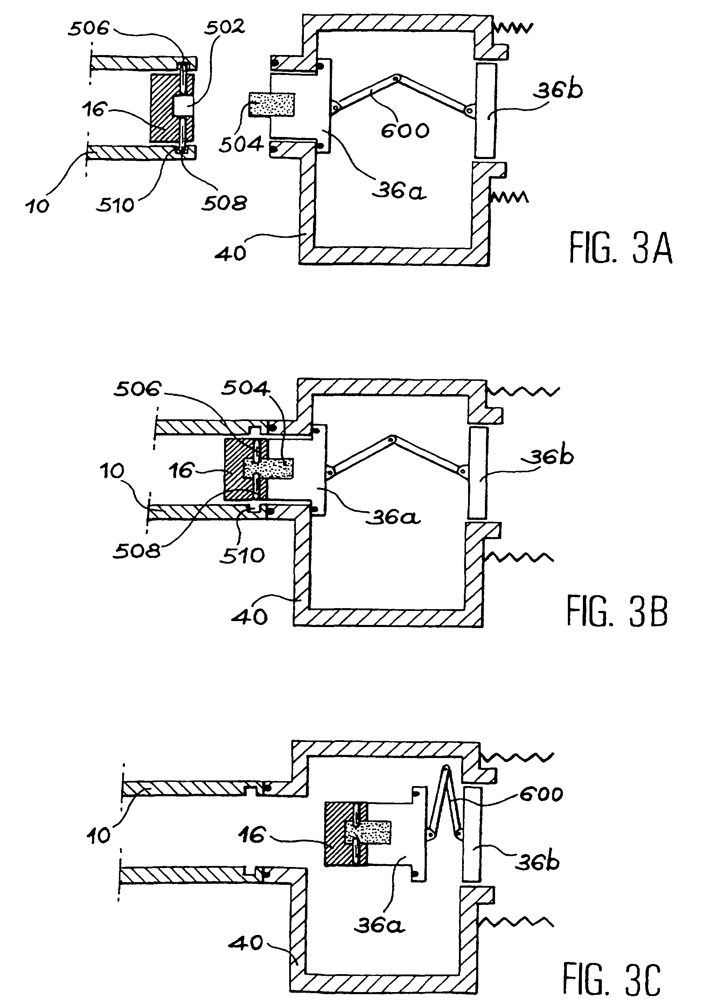

Les figures 3A à 3E montrent le principe de fonctionnement d'une autre variante de réalisation du système de transfert de l'invention.

Des éléments identiques ou similaires à ceux des figures 2A à 2D portent les mêmes références, on peut ainsi se reporter à leur sujet à la description qui précède.

Sur la figure 3A, on note que la porte 16 de la boîte de confinement 10, qui constitue le premier obturateur, présente une empreinte 502. Le deuxième obturateur 36a comporte un appendice 504, formant clé, qui présente une forme complémentaire de l'empreinte 502 et qui forme avec l'empreinte 502 un dispositif à baïonnette.

La description qui suit se réfère à un dispositif à baïonnette unique. Toutefois, les premier et deuxième obturateurs peuvent être équipés d'un tel dispositif en chacune de leurs extrémités latérales.

La référence 506 désigne un moyen de verrouillage de la porte 16 sur la boite de confinement 10.

Le moyen de verrouillage 506 dont un exemple de réalisation est décrit de façon plus détaillée dans la suite de la description, comporte par exemple des clavettes 508, s'engageant dans des gorges 510 de la boite de confinement 10.

L'appendice 504 formant clé est conçu de façon à, d'une part, déverrouiller le moyen de verrouillage 506 de la porte 16, lorsqu'il est introduit dans l'empreinte 502, et, d'autre part, à verrouiller la porte 16 de la boîte de confinement sur le deuxième obturateur 36a.

La solidarisation du deuxième obturateur 36a et de la porte 16, de même que le déverrouillage des clavettes 508 de la porte 16 sont visibles à la figure 3B.

Sur les figures 3A et 3B, on note également que le deuxième obturateur 36a et le troisième obturateur 36b sont reliés par un système de biellettes 600. Ces biellettes sont actionnables par un mécanisme non représenté sur les figures. La position occupée par les deuxième et troisième obturateurs sur les figure 3A et 3B est désignée par position "distale".

Lors d'une étape d'ouverture de la boîte de confinement, représenté à la figure 3C, les biellettes sont actionnées pour rapprocher le deuxième obturateur 36a du troisième obturateur 36b jusqu'à ce qu'ils occupent la position rapprochée représentée à la figure 3C désignée par position proximale.

On note par ailleurs, sur la figure 3C que la porte 16 est désormais solidaire du deuxième obturateur 36a.

Les biellettes 600 sont montées rotatives autour d'un axe (non représenté) dans la pièce d'embouchure pour faire pivoter les deuxième et troisième obturateurs entre une position angulaire dite horizontale dans laquelle les deuxième et troisième obturateurs sont disposés sensiblement parallèles à l'ouverture de l'unité de traitement et une position angulaire dite de transfert dans laquelle les deuxième et troisième obturateurs sont disposés sensiblement perpendiculairement à l'ouverture de l'unité de traitement.

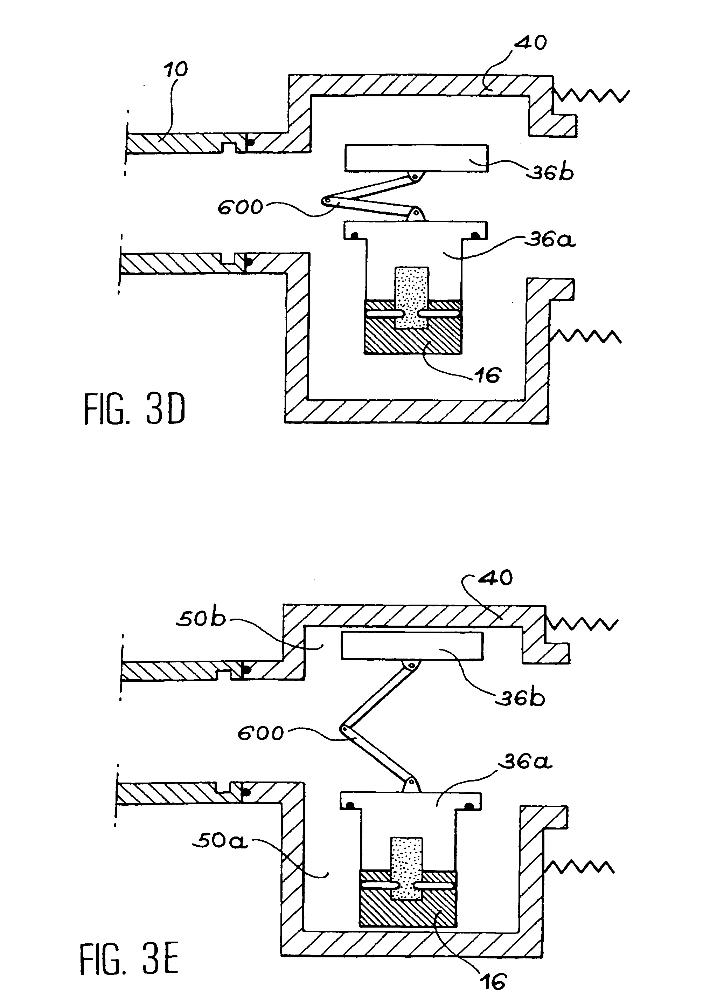

La position angulaire horizontale correspond à la position angulaire des obturateurs représentée aux figures 3A à 3C tandis que la position angulaire dite de transfert est visible aux figures 3D et 3E.

De façon plus précise sur la figure 3D, les deuxième et troisième obturateurs occupent leur position proximale et leur position angulaire dite de transfert. Dans ces positions, les ouvertures de la pièce d'embouchure sont libérées, mais le transfert de l'objet plat reste impossible dans la mesure où les obturateurs occupent le passage de l'objet dans la pièce d'embouchure.

Ainsi, comme le montre la figure 3E, les biellettes 600 sont de nouveau actionnées pour amener les obturateurs dans leur position distale. Lorsque les obturateurs sont dans la position angulaire de transfert et dans leur position distale, ils viennent occuper des logements 50a, 50b prévus dans la pièce d'embouchure 40 à cet effet.

Dans ces positions, le transfert de l'objet plat est possible. On peut noter à ce sujet que les biellettes sont situées de part et d'autre aux extrémités latérales des obturateurs afin de ne pas gêner le passage de l'objet plat.

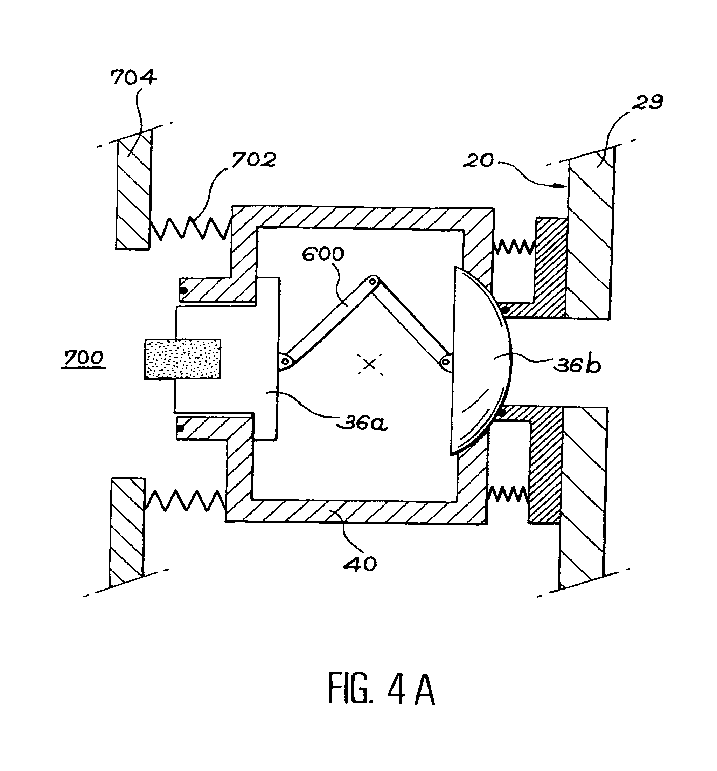

La figure 4A montre une réalisation particulière du dispositif des figures 3A à 3E. Cette réalisation est particulièrement adaptée à un transfert d'objets plats depuis des boîtes de confinement situées dans un sas à vide 700. Sur la figure 4A, des éléments identiques à ceux des figures 2A à 2D ou 3A à 3E portent les mêmes références.

A la différence des figures précédentes, on peut noter la présence d'un soufflet métallique 702 qui relie la face avant de la pièce d'embouchure 40 à des parois 704, qui délimitent une ouverture de transfert 706 du sas à vide.

Dans ce cas, le système d'accouplement de l'invention est utilisé comme un raccord entre le sas à vide et l'unité de traitement.

On peut noter par ailleurs que la porte 36b présente un bord de jointure en arc de cercle pour faciliter le pivotement dans la position angulaire de transfert.

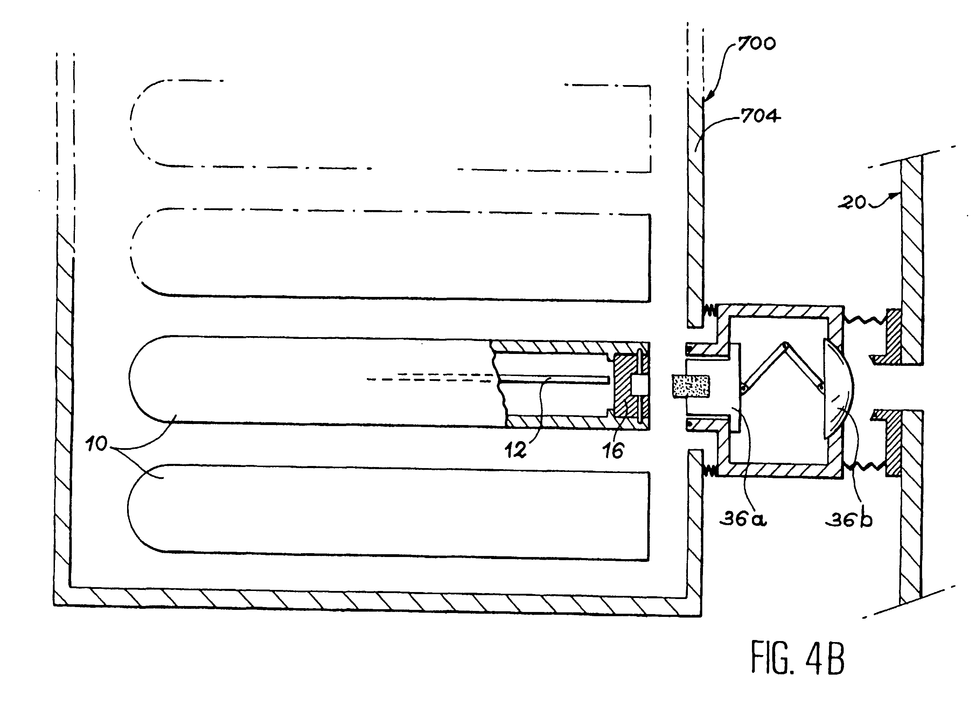

La figure 4B montre de façon plus détaillée le sas à vide 700 qui peut contenir plusieurs boîtes de confinement 10 à partir desquelles sont déchargés, ou dans lesquelles sont chargés, les objets plats. On peut noter sur la figure 4B que les boîtes 10 sont fermées par une porte 16 adaptable sur l'obturateur 36a du système de transfert.

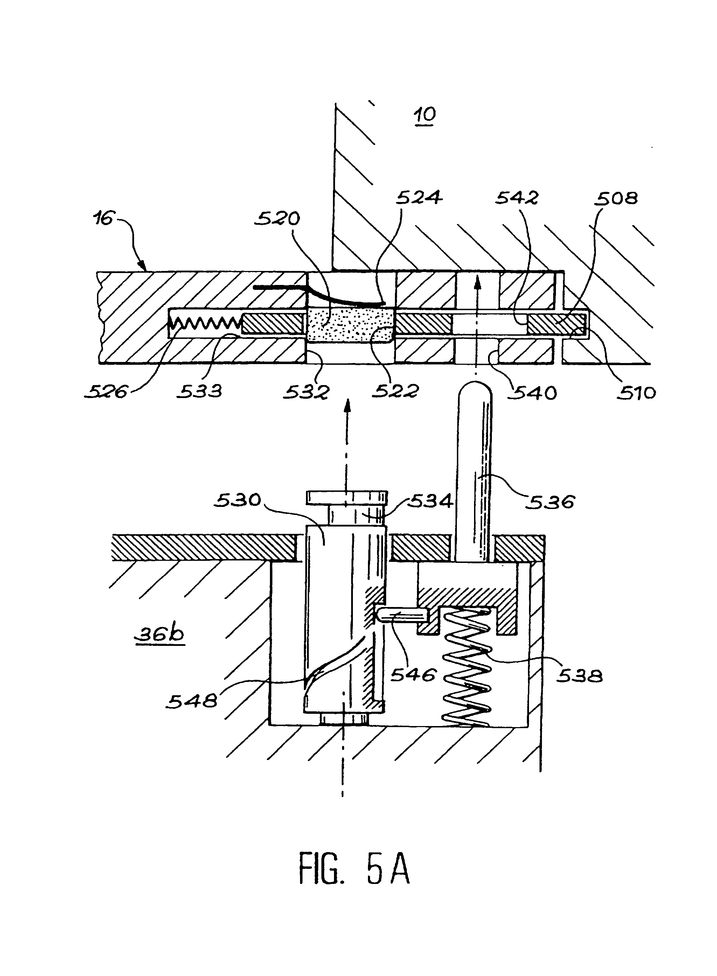

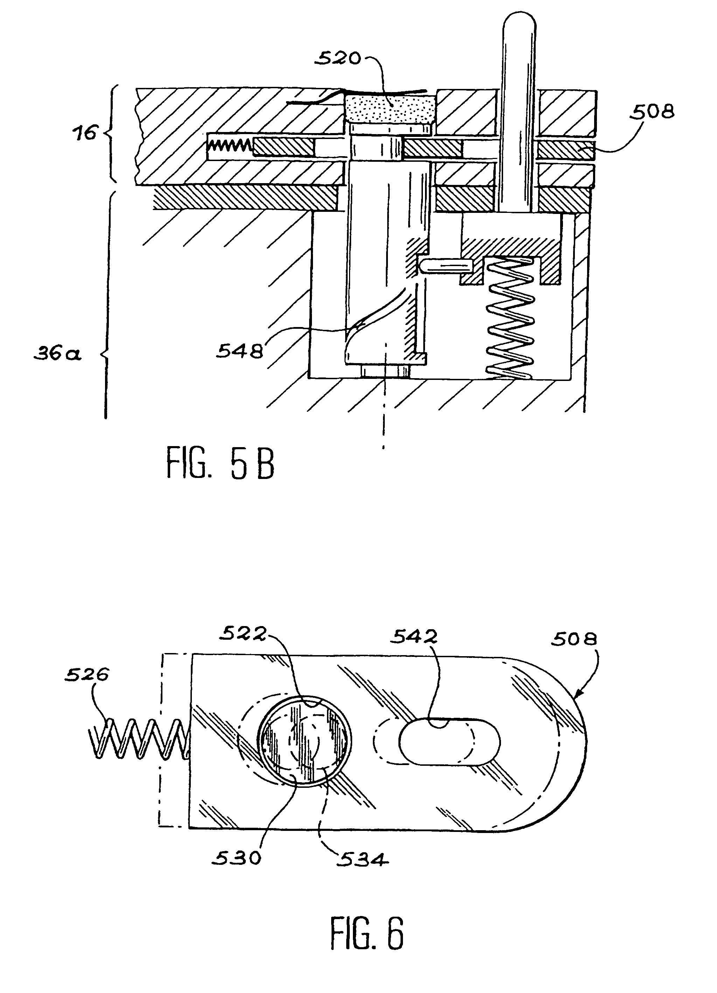

Les figures 5 et 6 décrites ci-après illustrent une réalisation particulière de moyens de verrouillage de la porte 16 sur le deuxième obturateur 36a et des moyens de verrouillage de la porte 16 sur la boîte de confinement 10.

Sur la figure 5A, les références 16 et 10 indiquent respectivement la porte de la boite de confinement et la boite de confinement elle-même représentée partiellement. Pour des raisons de simplification des éléments d'étanchéité entre la porte et la boite ne sont pas représentés sur cette figure.

La porte 16 est verrouillée sur la boîte 10 par une clavette 508 qui s'engage dans une gorge 510 de la boite 10.

La clavette est maintenue dans sa position de verrouillage au moyen d'une cale 520 qui vient s'engager dans un évidement 522 de la clavette sous l'action d'un ressort 524.

Par ailleurs, un ressort 526 est prévu pour tirer la clavette dans une position de déverrouillage lorsque la cale 520 est sortie de l'évidement 522.

Le deuxième obturateur 36a, partiellement représenté comprend une clé 530 montée rotative et apte à s'engager dans un évidement 532 de la porte 16.

Une tête de la clé 530 est ajustée de façon à repousser la cale 520 de la clavette 508 et à s'engager dans l'évidement 522 de cette clavette lorsque le deuxième obturateur 36a est appliqué contre la porte 16.

Les moyens de verrouillage/déverrouillage du deuxième obturateur présentent également un doigt 536 chargé par un ressort 538 qui se dresse verticalement depuis le deuxième obturateur.

Lorsque l'obturateur 36a est approché de la porte 16, le doigt 536 s'engage à travers des ouvertures 540, 542 pratiquées dans la porte 16 et la clavette 508 pour venir prendre appui contre le boitier 10.

Au fur et à mesure que l'obturateur 36a se rapproche de la porte 16, le doigt 536 est repoussé. Un pion 546 solidaire du doigt 536 s'engage dans une came 548 de la clé 530, faisant tourner celle-ci d'un demi-tour.

La tête de clé 530 est dotée d'une gorge excentrique 534 qui sous l'effet de la rotation d'un demi-tour induit par le recul du doigt 536, libère la clavette 508, qui, tirée par le ressort 526, se dégage de l'empreinte 510. La porte 16 est ainsi déverrouillée de la boite 10.

Ce faisant, la clavette 508 vient aussi s'engager dans la gorge excentrique pour verrouiller la porte 16 sur l'obturateur 36a, permettant ainsi l'escamotage de la porte. Cette situation est illustrée figure 5B.

La figure 6, représente les deux positions de la clavette 508. En trait plein, la position de verrouillage de la porte sur la boite et en trait pointillé la position de libération de la porte de la boîte, qui correspond aussi à la position de verrouillage de la porte 16 sur l'obturateur.

Par ailleurs, sous l'effet de la rotation de la clé, la tête de clé excentrique vient s'engager dans la porte 16 et verrouiller ainsi la porte 16 sur l'obturateur 36a. De façon plus précise, la tête de clé vient s'engager dans un guide 533 dans lequel coulisse la clavette 508.

Ainsi, le même mouvement de rotation de la clé permet, d'une part, de déverrouiller la porte de la boite et, d'autre part, de verrouiller la porte sur le deuxième obturateur qui peut ici être considéré comme une contre-porte.

Lorsque l'ensemble solidaire de la porte et de la contre-porte est alors retiré de la boîte 10, le doigt 536 revient dans sa position illustrée à la figure 5B sous l'action du ressort 538.

Pour refermer la boîte 10 (figure 5A) après un transfert d'objets et pouvoir ainsi libérer la boite 10 du système d'accouplement, pour accéder à d'autres boîtes 10, un mécanisme interne du système d'accouplement ramène l'ensemble de l'obturateur 36a et de la porte 16 représentés figure 5B dans la position d'accouplement avec la boîte de confinement.

Le doigt 536 vient à nouveau prendre appui sur la boîte 10 et est repoussé. La clé 530 tourne ainsi d'un demi-tour et la gorge excentrique repousse la clavette 508 en position de verrouillage de la porte 16 sur la boîte 10 (figure 5A). Dans cette position, il est possible de désolidariser la porte 16 de l'obturateur 36b, la clé 530 étant libérée de la clavette 508. Lors du retrait de l'obturateur 36a, la cale 520, repoussée par le ressort 524 vient prendre la place de la clé, verrouillant la clavette 508 en position, dans la position dans laquelle la porte 16 et la boîte 10 sont liées.

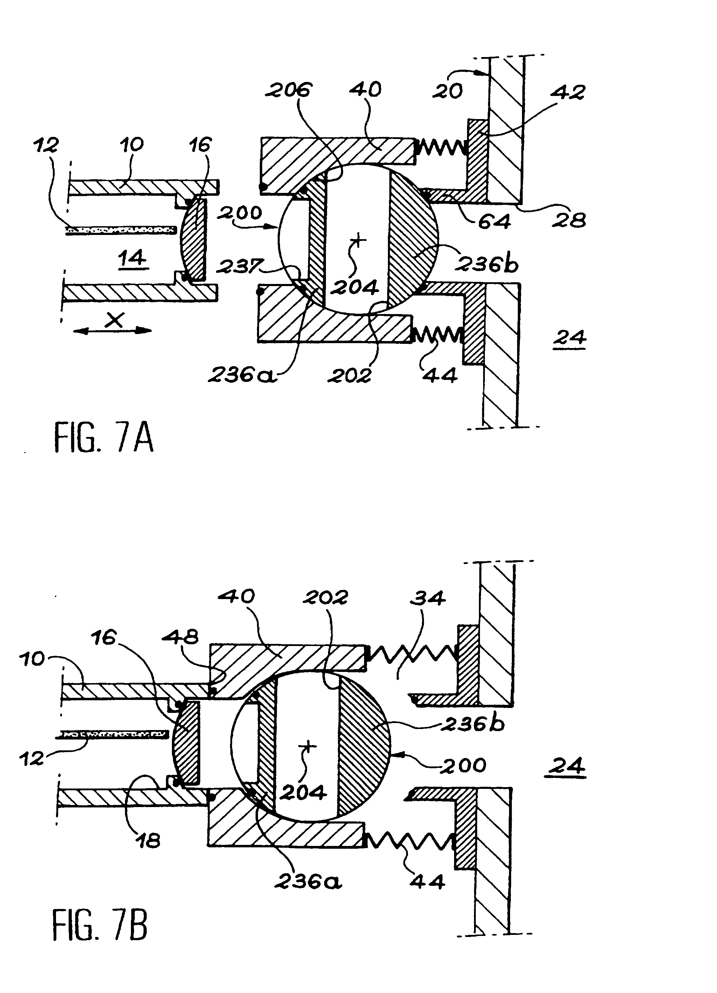

Les figures 7A à 7D montrent un example non conforme à l'invention. Ces figures correspondent aux mêmes étapes que les figures 2A à 2D respectivement.

Les deuxième et troisième obturateurs sont formés par une pièce cylindrique 200 unique vue selon une section transversale sur les figures. Elle présente une fente longitudinale 202 pour le passage de l'objet plat. Les dimensions de cette fente sont sensiblement les mêmes que celles des ouvertures 18 ou 28 de la boîte de confinement et de l'unité de traitement. A titre d'exemple, la fente présente une largeur de 1 à 3 cm pour une longueur de 20 à 30 cm.

La pièce cylindrique est montée dans la pièce d'embouchure 40 avec liberté de rotation selon son axe 204.

Lorsque la pièce d'embouchure 40 occupe sa position rétractée (figure 7A) la pièce cylindrique 200 est orientée de telle manière que la fente 202 soit sensiblement perpendiculaire à la direction de transfert X.

Des parties pleines du cylindre portant les références 236a et 236b sont respectivement en appui étanche contre un bord avant 206 de la pièce d'embouchure et contre le rebord 64 de l'embase 42. Le bord avant 206 présente une forme complémentaire du cylindre afin de permettre un contact étanche. L'étanchéité avec les parties 236a et 236b du cylindre peut par ailleurs être améliorée par des joints. Ces joints sont prévus, par exemple, sur l'extrémité du bord 64 et sur la partie 236a du cylindre.

Il apparaît que les parties 236a et 236b ont des fonctions identiques à celles des obturateurs 36a et 36b des figures 2A à 2D.

La figure 7B correspond au déplacement de la pièce d'embouchure de sa position rétractée vers sa position déployée. Son bord d'étanchéité 46 est appliqué contre la plage d'appui 48 de la boîte de confinement.

Lors de ce déplacement, le cylindre 200 garde sa position dans laquelle la fente 202 est sensiblement perpendiculaire à la direction de transfert. Mais, la partie 236b du cylindre est écartée du rebord 64 de l'embase 42 et les volumes intérieurs 24 et 34 de l'unité de traitement et des moyens d'accouplement sont mis en communication.

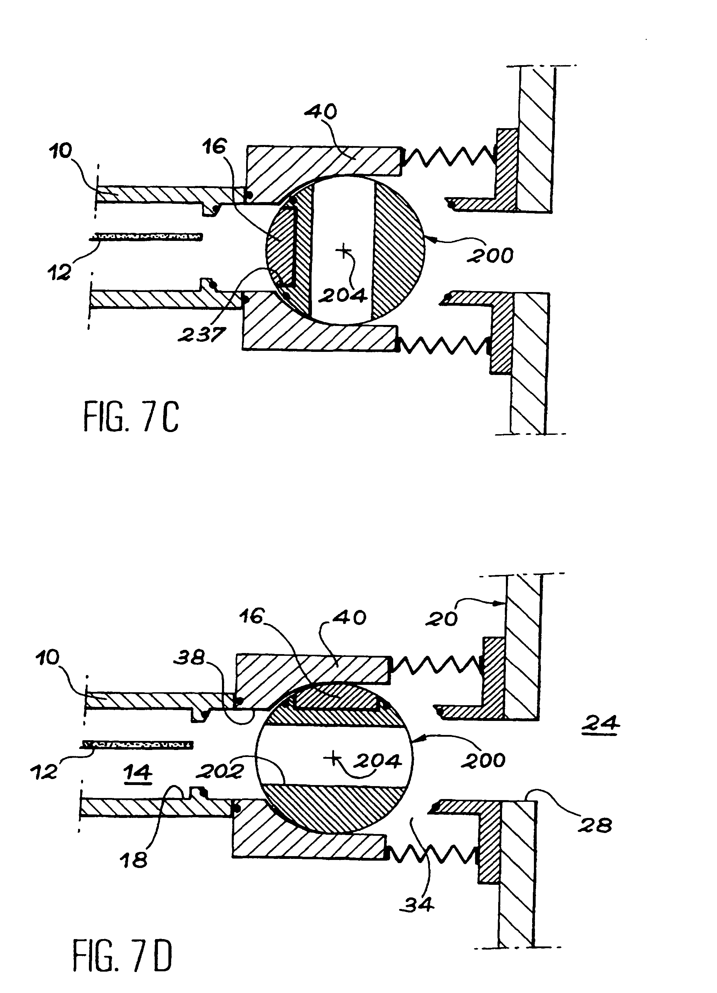

Dans une étape correspondant à la figure 7C, la porte 16 de la boite 10 qui initialement obturait l'ouverture 18 est déplacée contre la partie 236a du cylindre 200. La porte 16 est reçue dans un évidement 237 de la partie de cylindre 236a et y est verrouillée.

Des moyens moteurs, non visibles sur les figures permettent alors de faire pivoter le cylindre 200 d'un quart de tour pour sensiblement aligner la fente 202 avec les ouvertures 18 et 28 de la boite de confinement 10 et de l'unité de traitement 20.

Comme le montre la figure 7C, l'ouverture 38 de la pièce d'accouplement 40 est alors libérée et les volumes intérieurs 14, 24, 34 de la boîte 10, de l'unité de traitement 20 et des moyens d'accouplement sont mis en communication. Le transfert de l'objet plat peut alors avoir lieu de la façon décrite précédemment.

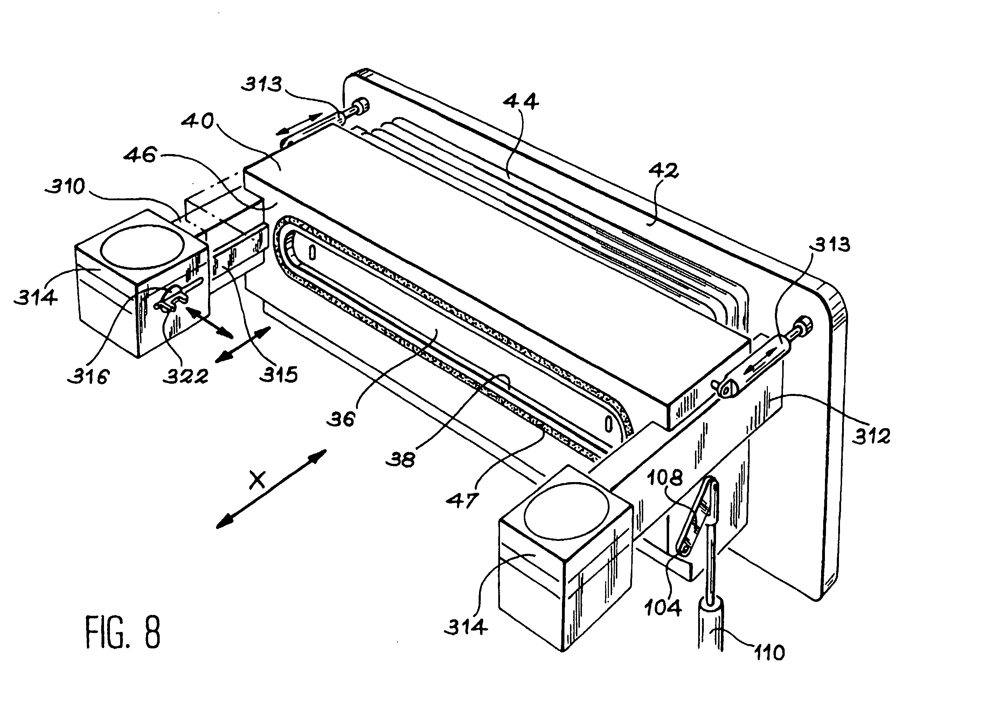

La figure 8 montre en perspective les moyens d'accouplement 30. On y retrouve les éléments essentiels des moyens d'accouplement déjà décrits, tels que l'embase 42, la pièce d'embouchure 40, le soufflet 44, et le bord d'étanchéité 46 équipé d'un joint 47.

Le joint 47 est disposé selon le pourtour de l'ouverture 38 qui présente une forme allongée compatible avec celle de l'objet plat non représenté.

Deux bras de maintien 310 et 312 se dressent perpendiculairement depuis l'embase 42 parallèlement à la direction X de déplacement de la pièce d'embouchure entre sa position rétractée et déployée.

Chaque bras est équipé en son extrémité d'un mécanisme 314 de saisie d'une boîte de confinement devant la pièce d'embouchure. Un tel mécanisme 314 est décrit plus en détail dans la suite du texte.

Les bras et les mécanismes de saisie ont une double fonction. Une première fonction est d'assurer un positionnement précis de la boîte de confinement devant la pièce d'embouchure. Une deuxième fonction est de maintenir fermement la boîte de confinement lorsque le bord d'étanchéité 46 est pressé contre celle-ci.

Des vérins 313, fixés de part et d'autre sur la pièce d'embouchure 40, sont également reliés à l'embase 42. Ces vérins permettent de déplacer la pièce d'embouchure 40 entre sa position rétractée et sa position déployée, selon la direction X. On peut enfin noter que la course de la pièce d'embouchure selon la direction X est guidée par les bras 310 et 312. Les bras 310 et 312 peuvent à cet effet supporter des guides 315.

Le mécanisme de pivotement de l'obturateur 36 est sommairement représenté sur la figure 4.

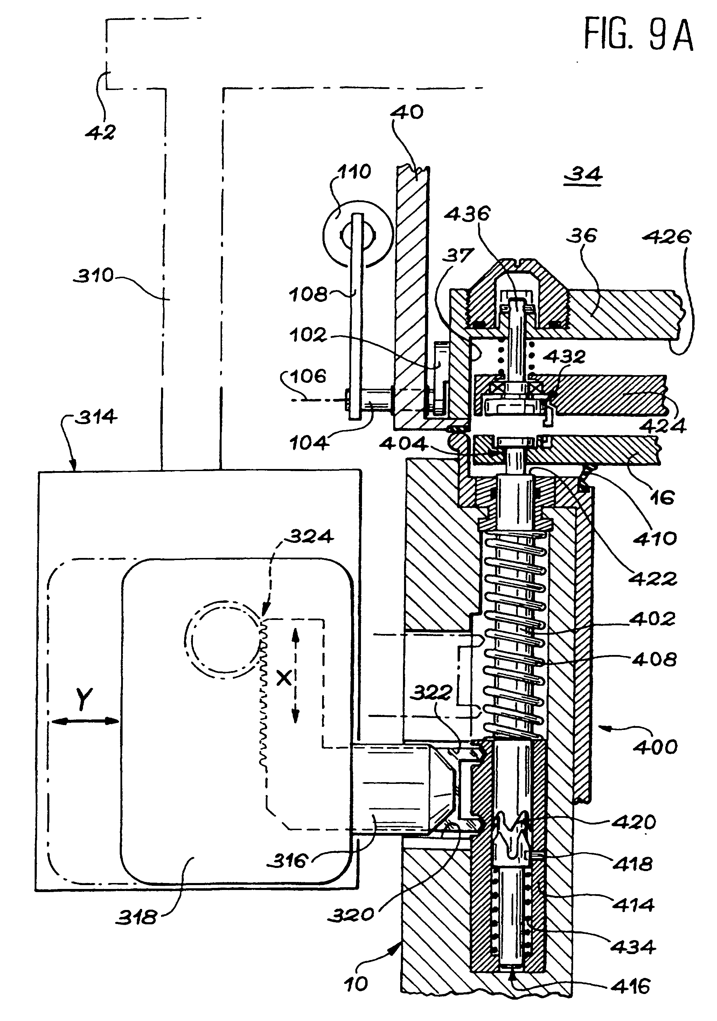

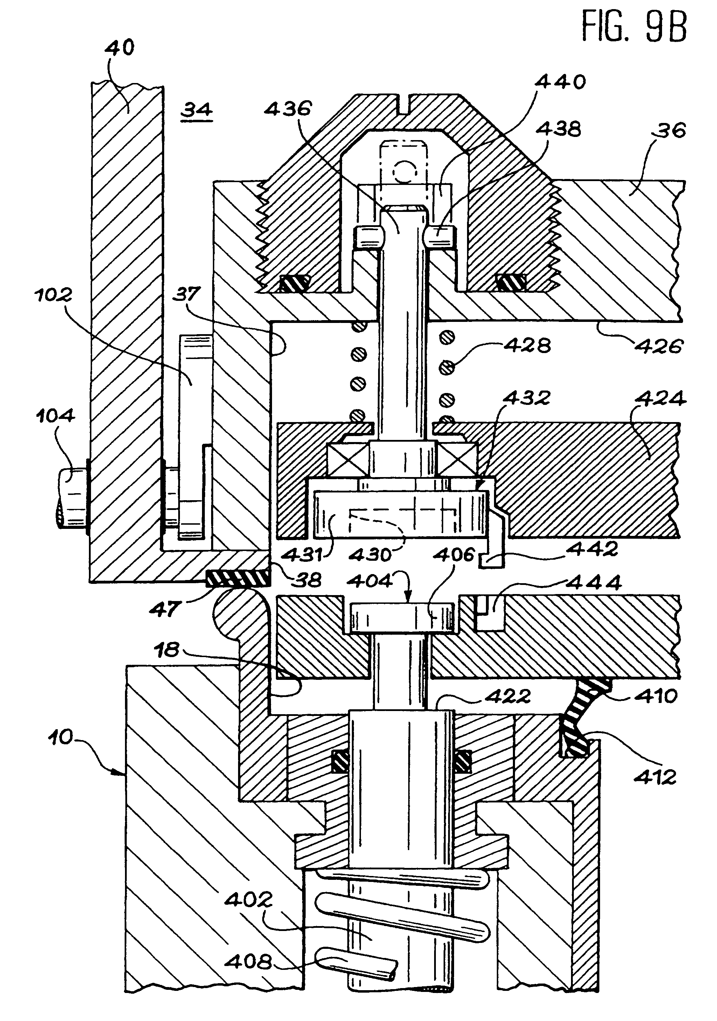

Les figures 9A et 9B montrent de façon détaillée un mécanisme du système de transfert permettant de pousser la porte 16 de la boîte de confinement 10 contre l'obturateur 36 et de verrouiller mutuellement ces deux pièces.

La figure 9A montre également une réalisation particulière du mécanisme permettant de faire avancer la porte 16 dans le logement 37, d'associer la porte 16 et l'obturateur 36, de libérer la porte 16 et enfin de faire pivoter l'obturateur 36 et la porte 16 d'une position d'obturation vers une position libérant un passage de la boîte de confinement vers l'unité de traitement.

La figure 9A montre enfin des détails du mécanisme de saisie 314.

Le mécanisme 314 comprend un téton 316 solidaire d'un plateau 318 mobile entre une position rétractée dans laquelle le téton est écarté de la boite 10 et une position avancée dans laquelle le téton vient en prise dans un trou 320 de la boite 10. Le plateau 318 est actionné par un vérin non représenté.

Par ailleurs, un actionneur mobile 322 à fourche encore désigné par fourche 322, est disposé dans une fente pratiquée dans le téton 316. La fourche 322 peut être déplacée parallèlement à la boite de confinement 10, c'est-à-dire parallèlement à la direction de transfert grâce à une crémaillère 324. La fourche permet d'actionner un mécanisme 400, décrit ci-après.

Lorsqu'une boîte de confinement est mise en place devant le système d'accouplement, le plateau 318 est déplacé vers la boîte de confinement selon la direction Y repérée sur la figure 9A. Le téton 316 et la fourche 322 sont donc déplacés simultanément pour venir en prise respectivement dans le trou 320 et dans des empreintes de réception des doigts de la fourche prévues sur une pièce du mécanisme 400.

Le téton 316 permet, lorsqu'il vient en prise dans le trou 320, de positionner de façon précise la boite 10. La fourche 322 peut alors être déplacée dans la direction X repérée sur la figure 9A pour actionner le mécanisme 400.

Le mécanisme 400 permet notamment de déplacer la porte 16 de la boite de confinement contre l'obturateur 36 des moyens d'accouplement, de verrouiller ces deux pièces l'une sur l'autre et de libérer la porte 16 pour permettre le pivotement. Ce mécanisme est disposé dans la boite de confinement, de chaque coté de son ouverture, pour faire face aux mécanismes de saisie 314.

Le mécanisme 400 comporte une biellette 402 dont une première extrémité 404 tournée vers l'ouverture 18 de la boîte de confinement 10 est équipée d'une pièce 406 formant clé.

La pièce 406 occupe une première position angulaire dans laquelle elle prend appui à l'extérieur contre la porte 16 et un ressort de rappel 408, agissant sur la biellette 402, permet de tirer la porte 16 contre la boîte de confinement. Un joint d'étanchéité 410 de la porte 16 est appuyé ainsi dans une gorge 412 correspondante sur la boîte 10. Le ressort de rappel 408 agit sur la biellette 402 par l'intermédiaire d'une douille 414 dans laquelle coulisse une deuxième extrémité 416 de la biellette 402, et par l'intermédiaire d'un pion 418, solidaire de la douille 414, qui prend appui dans une came 420 de la biellette 402.

La position décrite ci-dessus dans laquelle le ressort 408 rappelle la porte 16 contre la boite 10 correspond à une position de repos du mécanisme.

Cette position est occupée lorsque la boîte 10 n'est pas saisie par les mécanismes de saisie 314 ou lorsque le mécanisme 400 n'est pas actionné par la fourche 322.

Pour faire avancer la porte 16 contre l'obturateur 36 on actionne la fourche 322, en prise avec la douille 414, pour la déplacer en direction de la pièce d'embouchure 40.

La fourche 322 déplace la douille 414, et partant, la biellette 402 vers la pièce d'embouchure.

Lorsqu'un épaulement 422 de la première extrémité de la tige vient en appui contre une face de la porte 16 tournée vers l'intérieur de la boite de confinement 10, la porte 16 est également déplacée pour venir en contact avec une contre porte 424 de l'obturateur 36.

La pièce 406 formant clé vient se loger dans une empreinte 430 pratiquée dans la tête 431 d'un verrou 432 solidaire de la contre-porte.

Lorsque la biellette 402, actionnée par la fourche 322, continue à avancer, la porte 16 pousse la contre-porte 424 contre le corps 426 de l'obturateur 36, à l'encontre de l'action d'un ressort 428. Ce ressort 428 maintient initialement la contre-porte 424 écartée du corps 426 de l'obturateur.

Lorsque la contre-porte arrive en butée contre le corps 426 de l'obturateur 36, la biellette 402 ne peut plus avancer. Le mouvement de la fourche 322 en direction de la pièce d'embouchure fait alors avancer la douille 414 dans la même direction, à l'encontre d'un ressort de rappel 434 et du ressort 408. L'avancement de la douille 414 provoque un déplacement du pion 418 dans la came 420 et imprime un mouvement de rotation à la biellette 402.

Grâce à la clé 406 et la tête de verrou 431, le mouvement de rotation est transmis à une tige 436 du verrou 432 montée avec liberté de rotation sur la porte 16. Une goupille 438 située à l'extrémité de la tige 436 vient alors se positionner au sommet d'une came 440 pour verrouiller la contre-porte sur le corps 426 de l'obturateur 36.

En même temps un crochet 442, solidaire de la tête de verrou 431 vient se verrouiller dans une encoche 444 de la porte 16.

La porte 16 est alors verrouillée sur la contre-porte 424 qui l'est elle-même sur le corps 426 de l'obturateur.

Après le verrouillage, la fourche 322 est à nouveau déplacée en direction de sa position initiale représentée en trait plein sur la figure 9A. Lors de ce mouvement, la clé 406 est retirée de l'empreinte 430. Par ailleurs, suite au mouvement de rotation de la biellette 402, la clé 406 occupe une deuxième position angulaire, décalée de 90°, par exemple, dans laquelle elle ne prend pas appui sur la porte 16. Ainsi, le mouvement de la fourche 322 permet de retirer la biellette 402 du verrou 432 et de la porte 16.

L'ensemble formé par la porte 16, la contre-porte 424 et le corps 426 de l'obturateur peut alors être pivoté pour libérer conjointement l'ouverture 18 de la boite de confinement et l'ouverture 38 de la pièce d'embouchure. Cette opération correspond à la figure 1C déjà décrite.

Certaines références concernant le système de verrouillage ne sont reportées que sur la figure 9B qui est une vue agrandie d'un détail de la figure 9A.

Bien que leur disposition diffère un peu, on retrouve dans le mode de réalisation de la figure 5A les éléments du mécanisme de pivotement de l'obturateur 36.

Sur la figure 9A sont en particulier représentés le bras 102 relié à l'obturateur, le pivot 104 qui traverse la paroi de la pièce d'embouchure 40 selon l'axe 106, le bras 108 situé à l'extérieur de la pièce d'embouchure 40, et le vérin d'actionnement 110 solidaire de la pièce d'embouchure 40.

Un mécanisme identique à celui de la figure 9A existe sur le coté de la boite de confinement tourné vers le bras de maintien 312. Les mécanismes situés de part et d'autre de la boîte de confinement sont actionnés simultanément pour assurer le déplacement de la porte 16 ainsi que le verrouillage et le déverrouillage de la porte 16 avec l'obturateur 36.

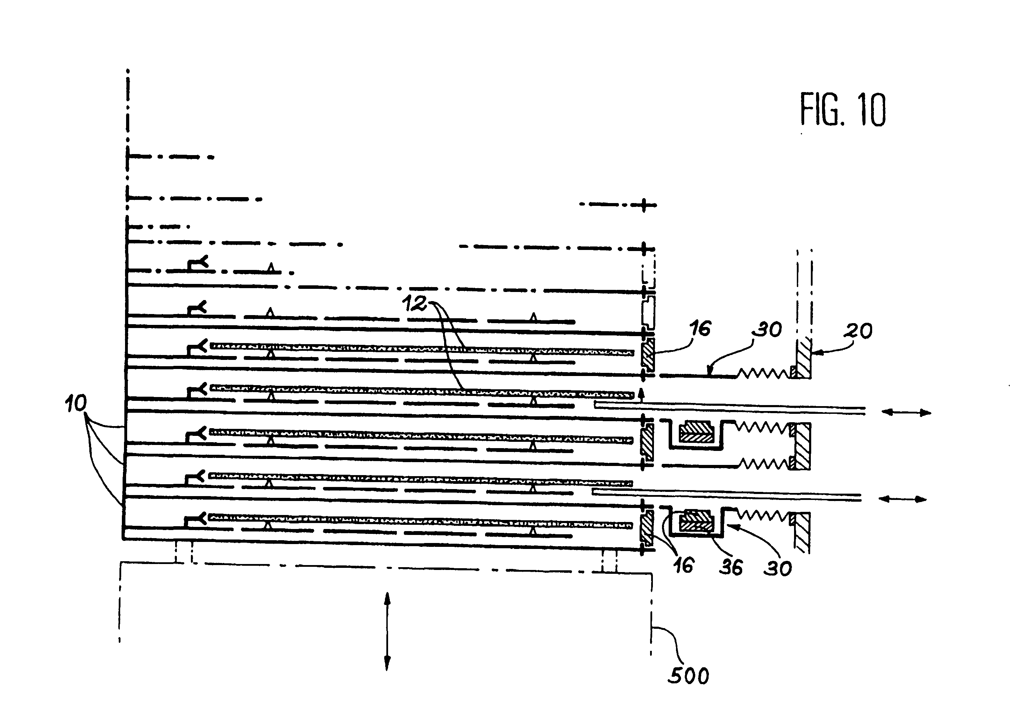

La description qui précède se rapporte à un système de transfert avec des moyens d'accouplement uniques. Toutefois, comme le montre la figure 10, celui-ci peut comporter une pluralité de tels moyens pour transférer simultanément plusieurs objets plats vers l'unité de traitement.

Selon une réalisation conforme à la figure 10, le système de transfert est équipé d'un plateau de support 500 pour recevoir un ensemble de boîtes de confinement 10 empilées. Chaque boîte de confinement contient dans cet exemple un unique objet plat 12. Le plateau est équipé de moyens moteurs non représentés pour être déplacé selon une direction verticale, c'est-à-dire perpendiculairement à la direction de transfert des objets plats. Ainsi, les boîtes de confinement de l'empilement peuvent être successivement mises en position devant un ou plusieurs moyens d'accouplement 30 afin de procéder au transfert d'un objet plat, soit des boîtes de confinement vers l'unité de traitement, soit de l'unité de traitement vers les boites de confinement.

Avantageusement, le plateau peut être équipé un système d'indexage optique pour garantir un positionnement précis des boîtes de confinement devant les moyens d'accouplement.

Finalement, grâce au système d'accouplement il est possible de maintenir en permanence autour des objets à traiter une atmosphère propre et pure.

Dans la réalisation décrite, le système d'accouplement comporte une partie d'équipement fixé à l'unité de traitement (moyens d'accouplement) et une partie d'équipement disposée dans chaque boîte de confinement (système de porte et de verrouillage). Toutefois, le système d'accouplement de l'invention n'est pas incompatible avec l'utilisation des moyens traditionnels d'alimentation des unités de traitement tels que des paniers de plaquettes de silicium, par exemple.

En effet, lorsque la pièce d'embouchure est dans sa position rétractée décrite précédemment, un transfert d'objets plats, en l'occurrence des plaquettes de silicium peut avoir lieu directement, en mettant l'obturateur dans sa position ouverte.

Le plateau 500 peut alors être chargé avec un râtelier de plaquettes de silicium ou un panier à étages, ordinaires. Bien sûr, il n'est pas possible alors de bénéficier des avantages propres au système de transfert de l'invention.

### DOCUMENTS CITES DANS LA DESCRIPTION

*(1)*
   EP-A-0 582 016
*(2)*
   EP-A-0 582 018
*(3)*
   FR-A-2 697 000
*(4)*
   EP-A-0 589 812
*(5)*
   GB-A-2 249 145

## Revendications

1. Système d'accouplement pour un transfert confiné d'un objet plat (12) d'une boîte de confinement (10) comportant une première ouverture latérale de transfert (18), avec un premier obturateur (16), vers une unité (20) de traitement de l'objet plat, comportant au moins une seconde ouverture de transfert (28), le système comportant :
- des moyens (30) d'accouplement étanche de l'ouverture (18) de la boîte de confinement (10) avec l'ouverture (28) de l'unité de traitement (20), ces moyens présentant un deuxième obturateur (36, 36a), les premier et deuxième obturateurs comportant des premiers moyens (502, 504, 530, 533, 534) de verrouillage/déverrouillage mutuel permettant de verrouiller le premier obturateur (16) sur le deuxième obturateur (36a),
- des moyens de libération (104) aptes à ouvrir le premier obturateur (16) accouplé au deuxième obturateur (36),
**caractérisé en ce que** les moyens d'accouplement comportent une embase (42) étant solidaire de l'unité de traitement (20) et entourant l'ouverture (28) de l'unité de traitement (20), une pièce d'embouchure (40), un raccord étanche (44) reliant la pièce d'embouchure (40) à l'embase (42) et un mécanisme (313) pour déplacer la pièce d'embouchure selon une direction de transfert (X), entre une position rétractée, permettant la mise en place de la boîte (10) devant les moyens (30) d'accouplement et une position déployée dans laquelle la pièce d'embouchure (40) est placée de façon étanche contre la boîte de confinement (10),
- et **en ce que** les moyens d'accouplement comportent en outre un troisième obturateur (36b) associé à la seconde ouverture, et disposé dans la pièce d'embouchure (40) sur un côté tourné vers l'unité de traitement (20) et dans lequel le deuxième obturateur est relié au troisième obturateur au moyen de biellettes (600) actionnables entre une position dite distale dans lequel les deuxième (36a) et troisième (36b) obturateurs sont écartés l'un de l'autre et une position dite proximale dans laquelle les deuxième (36a) et troisième (36b) obturateurs sont rapprochés l'un de l'autre.

2. Système selon la revendication 1, **caractérisé en ce que** l'embase (42) comporte des brides (310, 312) de saisie de la boîte de confinement, disposées de part et d'autre de la pièce d'embouchure.

3. Système selon la revendication 2, **caractérisé en ce que** les brides (310, 312) supportent des guides (315) pour guider longitudinalement la pièce d'embouchure (40).

4. Système selon la revendication 1, **caractérisé en ce que** la pièce d'embouchure (40) présente un bord d'êtanchéité (46) et chaque boîte de confinement (10) présente une plage d'appui (48) entourant la première ouverture (18) et apte à recevoir le bord d'étanchéité (46).

5. Système selon l'une quelconque des revendications 1 à 4, **caractérisé en ce que** la pièce d'embouchure (40) comporte au moins un logement (50, 50a) des premier et deuxième obturateurs (16, 36).

6. Système selon la revendication 1, **caractérisé en ce que** le premier obturateur (16) est une porte de la boîte de confinement, et **en ce que** les moyens de libération des obturateurs comportent un mécanisme (314, 404, 432) pour déplacer la porte (16) contre le deuxième obturateur (36) et pour verrouiller la porte (16) sur le deuxième obturateur (36).

7. Système selon la revendication 6, **caractérisé en ce que** le mécanisme pour déplacer la porte contre le deuxième obturateur comporte dans chaque boîte de confinement (10), d'une part de la première ouverture (18) une biellette (402) pour pousser la porte vers le deuxième obturateur.

8. Système selon la revendication 7, **caractérisé en ce que** le mécanisme (314, 404, 432) pour verrouiller la porte (16) sur le deuxième obturateur présente un verrou (432), solidaire de deuxième obturateur.

9. Système selon la revendication 8, **caractérisé en ce que** la biellette comporte une clé (406) coopérant avec le verrou (432).

10. Système selon la revendication 6, **caractérisé en ce que** le deuxième obturateur (36) comporte une contre-porte (424) de réception de la porte (16) de la boîte de confinement, la contre-porte étant montée sur un corps (426) du second obturateur.

11. Système selon la revendication 10, **caractérisé en ce que** le deuxième obturateur comporte un évidement (37) pour recevoir la porte (16) de la boîte de confinement, lorsqu'elle est solidarisée contre l'obturateur.

12. Système selon la revendication 2, **caractérisé en ce que** chaque bride est équipée d'un actionneur (322) coopérant avec un mécanisme (400) de la boîte de confinement, pour actionner les biellettes.

13. Système selon la revendication 6, **caractérisé en ce que** les moyens de libération des premier et second obturateurs comportent un mécanisme de pivotement relié au second obturateur pour faire pivoter le second obturateur (36) et la porte (16) de la boîte de confinement entre une position d'obturation et une position d'ouverture.

14. Système selon la revendication 1, dans lequel les premiers moyens de verrouillage comportent au moins un dispositif à baïonnette (502, 504) avec des pièces de verrouillage de forme complémentaire disposées respectivement sur les premier (16) et deuxième obturateurs (36a).

15. Système selon la revendication 14, dans lequel la pièce de verrouillage solidaire du deuxième obturateur est une clé (530).

16. Système selon la revendication 15, dans lequel le premier obturateur (16) comporte en outre des deuxièmes moyens (508, 510) de verrouillage/déverrouillage pour rendre le premier obturateur solidaire de la boîte de confinement (10), les deuxièmes moyens de verrouillage/déverrouillage étant actionnables par la clé (530) du deuxième obturateur.

17. Système selon la revendication 15 comprenant des moyens (536, 546, 548) de mise en rotation de la clé (530), actionnables par déplacement de la pièce d'embouchure de sa position rétractée vers sa position déployée.

18. Système selon la revendication 17, dans lequel les moyens de mise en rotation de la clé comportent une came (548) et un doigt coulissant (536) apte à prendre appui sur la boîte de confinement (10) et à être repoussé lors du déplacement de la pièce d'embouchure vers la boîte de confinement, le doigt présentant un pion (546) en prise avec la came (548) pour faire tourner la clé (530) lorsque le doigt est repoussé.

19. Système selon la revendication 16, dans lequel les deuxièmes moyens de verrouillage/déverrouillage comportent une clavette (508), actionnable par la clé (530), et comportent une cale (520) pour maintenir la clavette dans une position de verrouillage lors d'un retrait de la clé.

20. Système selon la revendication 1, dans lequel les biellettes (600) sont montées rotatives autour d'un axe dans la pièce d'embouchure (40) pour faire pivoter les deuxième et troisième obturateurs (36a, 36b) entre une position dite horizontale dans laquelle les deuxième et troisième obturateurs sont disposés sensiblement parallèles à l'ouverture de l'unité de traitement et une position dite de transfert dans laquelle les deuxième et troisième obturateurs sont disposés perpendiculairement à l'ouverture de l'unité de traitement.

21. Système selon la revendication 20, dans lequel la pièce d'embouchure comporte des logements (50a, 50b) pour recevoir les deuxième et troisième obturateurs.

22. Système selon la revendication 1, **caractérisé en ce que** le troisième obturateur (36b) est une porte (36b) et **en ce que** l'embase (42) comporte un rebord (64) d'étanchéité entourant la deuxième ouverture (28), la porte (36b) étant appuyée de façon étanche contre ledit rebord d'étanchéité de l'embase (42) lorsque la pièce d'embouchure (40) est dans la position rétractée, et la porte (36b) étant séparée du rebord d'étanchéité lorsque la pièce d'embouchure (40) est dans la position déployée.

23. Système selon la revendication 1, **caractérisé en ce qu'**il comporte un plateau de support (500) pouvant recevoir un empilement de boîtes de confinement (10), le plateau étant mobile selon une direction perpendiculaire à la direction de transfert (X), pour disposer successivement les boîtes de confinement devant les moyens d'accouplement (30).

## Patentansprüche

1. Kupplungssystem für den geschlossenen Transfer eines flachen Gegenstands (12) von einem Verschlussbehälter (10) mit einer ersten seitlichen Transferöffnung (18), versehen mit einem ersten Verschluss (18), zu einer Behandlungseinheit (20) des flachen Gegenstands mit wenigstens einer zweiten Transferöffnung 28, wobei dieses System umfasst:
- Einrichtungen (30) für ein dichtes Kuppeln der Öffnung (18) des Verschlussbehälters (10) mit der Öffnung (28) der Behandlungseinheit (20), wobei diese Einrichtungen einen zweiten Verschluss (36, 36a) aufweisen und der erste und der zweite Verschluss erste Einrichtungen (502, 504, 530, 533, 534) zur gegenseitigen Verriegelung/Entriegelung umfassen, die ermöglichen, den ersten Verschluss (16) in dem zweiten Verschluss (36a) zu verriegeln,
- Freigabeeinrichtungen (104) zum Öffnen des mit dem zweiten Verschluss (36) gekuppelten ersten Verschlusses (16),
**dadurch gekennzeichnet,**
- **dass** die Kupplungseinrichtungen (30) gebildet werden durch eine Befestigungsplatte (42), fest verbunden mit der Behandlungseinheit (20) und die Öffnung (28) der Behandlungseinheit (20) umgebend, ein Erweiterungsstück (40), eine das Erweiterungsstück (40) mit der Befestigungsplatte (42) verbindende dichte Verbindungseinrichtung (44) und einen Mechanismus (313), um das Erweiterungsstück in einer Transferrichtung (X) zu verschieben zwischen einer zurückgezogenen Position, welche der Stellung des Behälters (10) vor den Kupplungseinrichtungen (30) entspricht, und einer ausgefahrenen Position, in der das Erweiterungsstück (40) in abdichtender Weise an den Verschlussbehälter (10) angedockt ist,
- und **dass** die Kupplungseinrichtungen außerdem einen dritten Verschluss (36b) umfassen, verbunden mit dem zweiten Verschluss und in dem Erweiterungsstück (40) auf einer der Behandlungseinheit (20) zugewandten Seite angeordnet, wobei der zweite Verschluss mit dem dritten Verschluss durch Anlenkstangen (600) verbunden ist, die betätigt werden können zwischen einer sogenannten distalen Position, in welcher der zweite (36a) und der dritte (36b) Verschluss voneinander entfernt sind, und einer sogenannten proximalen Position, in welcher der zweite (36a) und der dritte (36b) Verschluss einander angenähert sind.

2. System nach Anspruch 1, **dadurch gekennzeichnet, dass** die Befestigungsplatte (42) beiderseits des Erweiterungsstücks angeordnete Flansche (310, 312) zum Greifen des Verschlussbehälters umfasst.

3. System nach Anspruch 2, **dadurch gekennzeichnet, dass** die Flansche (310, 312) Führungen (315) umfassen, um das Erweiterungsstück (40) in Längsrichtung zu führen.

4. System nach Anspruch 1, **dadurch gekennzeichnet, dass** das Erweiterungsstück (40) einen Dichtungsrand (46) umfasst und jede Verschlusskammer (10) einen die erste Öffnung (18) umgebenden Abstützbereich (48) für den Dichtungsrand (46) aufweist.

5. System nach einem der Ansprüche 1 bis 4, **dadurch gekennzeichnet, dass** das Erweiterungsstück (40) wenigstens einen Aufnahmeraum (50, 50a) für den ersten und zweiten Verschluss (16, 36) umfasst.

6. System nach Anspruch 1, **dadurch gekennzeichnet, dass** der erste Verschluss (16) eine Tür des Verschlussbehälters ist, und **dadurch**, dass die Freigabeeinrichtungen der Verschlüsse einen Mechanismus (314, 404, 432) umfassen, um die Tür (16) in Richtung des zweiten Verschlusses (36) zu verschieben und um die Tür (16) in diesem zweiten Verschluss (36) zu verriegeln.

7. System nach Anspruch 6, **dadurch gekennzeichnet, dass** der Mechanismus zu Verschieben der Tür in Richtung des zweiten Verschlusses in jeder Verschlusskammer (10) auf einer Seite der ersten Öffnung (18) eine Stange (402) umfasst, um die Tür gegen den zweiten Verschluss zu drücken.

8. System nach Anspruch 7, **dadurch gekennzeichnet, dass** der Mechanismus (314, 404, 432) zum Verriegeln der Tür (16) in dem zweiten Verschluss einen mit dem zweiten Verschluss verbundenen Riegel (432) aufweist.

9. System nach Anspruch 8, **dadurch gekennzeichnet, dass** die Stange einen Schlüssel (406) umfasst, der mit dem Riegel (432) kooperiert.

10. System nach Anspruch 6, **dadurch gekennzeichnet, dass** der zweite Verschluss (36) eine Vortür (424) zur Aufnahme der Tür (16) des Verschlussraums umfasst, wobei diese Vortür auf ein Hauptstück (426) des zweiten Verschlusses montiert ist.

11. System nach Anspruch 10, **dadurch gekennzeichnet, dass** der zweite Verschluss eine Aussparung (37) für die Aufnahme der Tür (16) des Verschlussbehälters umfasst, wenn dieser mit dem Verschluss vereinigt wird.

12. System nach Anspruch 2, **dadurch gekennzeichnet, dass** jeder Flansch eine Betätigungseinrichtung (322) umfasst, die mit einem Mechanismus (400) des Verschtussbehälters kooperiert, um die Anlenkstangen zu betätigen.

13. System nach Anspruch 6, **dadurch gekennzeichnet, dass** die Freigabeeinrichtungen des ersten und des zweiten Verschlusses einen mit dem zweiten Verschluss verbundenen Schwenkmechanismus umfassen, um den zweiten Verschluss 3 und die Tür 16 des Verschlussbehälters zwischen einer Verschlussstellung und einer Öffnungsstellung zu schwenken.

14. System nach Anspruch 1, bei dem die ersten Verriegelungseinrichtungen wenigstens eine Bajonettverschlussvorrichtung (502, 504) mit Veniegelungsteilen von komplementärer Form in jeweils dem ersten (16) und dem zweiten (36a) Verschluss umfassen.

15. System nach Anspruch 14, bei dem das mit dem zweiten Verschluss verbundene Verriegelungsteil ein Schlüssel (530) ist.

16. System nach Anspruch 15, bei dem der erste Verschluss (16) außerdem zweite Verriegelungs-/Entriegelungseinrichtungen (508, 510) umfasst, um den ersten Verschluss mit dem Verschlussbehälter (10) zu verbinden, wobei die zweiten Verriegelungs-/Entriegelungseinrichtungen durch den Schlüssel (530) des zweiten Verschlusses zu betätigen sind.

17. System nach Anspruch 15, Dreheinrichtungen (536, 546, 548) des Schlüssels (530) umfassend, zu betätigen durch Verschiebung des Erweiterungsstücks aus seiner zurückgezogenen Position in seine ausgefahrene Position.

18. System nach Anspruch 17, dass die Schlüsseldreheinrichtungen eine Steuerkurve (548) und einen verschiebbaren Finger (536) umfassen, der sich auf dem Verschlussbehälter (10) abstützen kann und bei der Verschiebung des Erweiterungsstücks zurückgedrückt wird in Richtung Verschlussbehälter, wobei dieser Finger einen in die Steuerkurve (548) eingreifenden Stift (546) umfasst, der den Schlüssel (530) dreht, wenn der Finger zurückgedrückt wird.

19. System nach Anspruch 16, bei dem die zweiten Verriegelungs-/Entriegelungseinrichtungen einen Keil (508) umfassen, zu betätigen durch den Schlüssel (530), sowie ein Hemmstück (520) umfassen, das bei einem Zurückziehen des Schlüssels den Keil in einer Veniegelungsstellung hält.

20. System nach Anspruch 1, bei dem die in das Erweiterungsstück (40) eingebauten Anlenkstangen (600) so um eine Achse drehbar sind, dass sie den zweiten und den dritten Verschluss (36a, 36b) zwischen einer sogenannten Horizontalposition, in welcher der zweite und der dritte Verschluss im Wesentlichen parallel zu der Öffnung der Behandlungseinheit angeordnet sind, und einer sogenannten Transferposition, in welcher der zweite und der dritte Verschluss senkrecht zu der Öffnung der Behandlungseinheit angeordnet sind, schwenken können.

21. System nach Anspruch 20, bei dem die in das Erweiterungsstück Aufnahmeräume (50a, 50b) für den zweiten und dritten Verschluss umfasst.

22. System nach Anspruch 1, **dadurch gekennzeichnet, dass** der dritte Verschluss (36b) eine Tür (36b) ist, und **dadurch**, dass die Befestigungsplatte (42) einen Dichtungsrand (64) umfasst, der die zweite Öffnung (28) umgibt, wobei die Tür (36b) in abdichtender Weise gegen den Dichtungsrand der Befestigungsplatte (42) gedrückt wird, wenn das Erweiterungsstück (40) sich in der zurückgezogenen Position befindet, und die Tür (36b) von dem Dichtungsrand getrennt ist, wenn das Erweiterungsstück (40) sich in der ausgefahrenen Position befindet.

23. System nach Anspruch 1, **dadurch gekennzeichnet, dass** es eine Trägerplatte (500) umfasst, die einen Stapel von Verschlussbehältem (10) aufnehmen kann, wobei diese Platte in einer zu der Transferrichtung (X) senkrechten Richtung verschiebbar ist, um die Verschlussbehälter nacheinander vor dem Kupplungseinrichtungen (30) anordnen zu können.

## Claims

1. Coupling system for transfer of a flat object (12) from a confinement box (10) incorporating a first side opening (18) for transfer, with a first shutter (16), towards a processing unit (20) of the flat object, incorporating at least one second opening (28) for transfer, the system comprising:
- means (30) for the sealed coupling of opening (18) of confinement box (10) with opening (28) of the processing unit (20), these means having a second shutter (36, 36a), the first and second shutters incorporating first mutual locking/unlocking means (502, 504, 530, 533, 534), making it possible to lock the first shutter (16) on the second shutter (36a),
- release means (104) able to open the first shutter (16) coupled to the second shutter (36a),
**characterized in that** the coupling means comprise a base support (42) fixed to processing unit (20) and surrounding opening (28) of processing unit (20), a mouth part (40), a sealed connector (44) connecting mouth part (40), to base support (42), and a mechanism (313) for moving the mouth part in a transfer direction (X), between a retracted position, allowing box (10) to be placed in front of coupling means (30), and an opened position in which mouth part (40) is applied in sealed manner against confinement box (10) and **in that** the coupling means also incorporate a third shutter (36b) associated with the second opening and placed in the mouth part (40) on a side turned towards the processing unit (20) and in which the second shutter is connected to the third shutter by means of small rods (600) actuatable between a so-called distal position in which the second (36a) and third (36b) shutters are spaced apart from one another and a so-called proximal position in which the second (36a) and third (36b) shutters are close to one another.

2. System in accordance with claim 1, **characterized in that** base support (42) comprises flanges (310, 312) for grasping the confinement box placed either side of the mouth part.

3. System in accordance with claim 2, **characterized in that** flanges (310, 312) carry guides (315) to guide mouth part (40) longitudinally.

4. System in accordance with claim 1, **characterized in that** mouth part (40) has a sealing rim (46) and each confinement box (10) has a support band (48) surrounding the first opening (18) into which fits the sealing rim (46).

5. System in accordance with any of claims 1 to 4, **characterized in that** mouth part (40) comprises at least one housing (50, 50a) for the first and second shutters (16, 36).

6. System in accordance with claim 1, **characterized in that** the first shutter (16) is a door of the confinement box, and **in that** the means of releasing the shutters comprise a mechanism (314, 404, 432) for moving door (16) against the second shutter (36) and for locking door (16) on the second shutter (36).

7. System in accordance with claim 6, **characterized in that** the mechanism for moving the door against the second shutter comprises, in each confinement box (10) on one side of first opening (18), a small connecting rod (402) to push the door towards the second shutter.

8. System in accordance with claim 7, **characterized in that** the mechanism (314, 404, 432) for locking door (16) on the second shutter has a bolt (432) integral with the second shutter.

9. System in accordance with claim 8, **characterized in that** the small connecting rod comprises a key (406) cooperating with bolt (432).

10. System in accordance with claim 6, **characterized in that** second shutter (36) comprises a counter-door (424) to receive door (16) of the confinement box, the counter-door being mounted on a body (426) of the second shutter.

11. System in accordance with claim 10, **characterized in that** the second shutter incorporates a recess (37) which takes door (16) of the confinement box when it is connected against the shutter.

12. System in accordance with claim 2, **characterized in that** each flange is fitted with an actuator (322) cooperating with a mechanism (400) of the confinement box, to actuate the small connecting rods.

13. System in accordance with claim 6, **characterized in that** the means for releasing the first and second shutters comprise a pivoting mechanism connected to the second shutter to cause the second shutter (36) and door (16) of the confinement box to pivot between a blocking position and an opening position.

14. System in accordance with claim 1, in which the first locking means comprise at least one bayonet device (502, 504) having locking parts of complementary shape placed respectively on the first (16) and second (36a) shutters.

15. System in accordance with claim 14, in which the locking part integral with the second shutter is a key (530).

16. System in accordance with claim 15, in which the first shutter (16) also comprises second locking/unlocking means (508, 510) to make the first shutter integral with the confinement box (10), the second locking/unlocking means being actuated by the key (530) of the second shutter.

17. System in accordance with claim 15 comprising means (536, 546, 548) causing key (530) to rotate, operated by moving the mouth part from its retracted position to its opened position.

18. System in accordance with claim 17, in which the means causing the key to rotate comprise a cam (548) and a sliding finger (536) able to support itself on confinement box (10) and to be pushed back during the movement of the mouth part towards the confinement box, the finger having a pawn (518) engaged in the cam (548) to turn the key (530) when the finger is recoiled.

19. System in accordance with claim 16, in which the second locking/unlocking means comprise a cotter-pin (508) actuated by the key (530) and comprising a wedge (520) to hold the cotter-pin in locking position when the key is withdrawn.

20. System in accordance with claim 1, in which small connecting rods (600) are mounted so that they can rotate around an axis within mouth part (40) to cause the second and third shutters (36a, 36b) to pivot between a so-called horizontal position in which the second and third shutters are positioned substantially parallel to the opening of the processing unit, and a so-called transfer position in which the second and third shutters are positioned perpendicular to the opening of the processing unit.

21. System in accordance with claim 20, in which the mouth part comprises housings (50a, 50b) to house the second and third shutters.

22. System in accordance with claim 1, **characterized in that** the third shutter (36b) is a door (36b) and **in that** base support (42) incorporates a sealing rim (64) surrounding the second opening (28), door (36b) being pressed in sealed manner against said sealing rim of support base (42) when mouth part (40) is in retracted position, and door (36b) being separated away from the sealing rim when mouth part (40) is in opened position.

23. System in accordance with claim 1, **characterized in that** it comprises a support tray (500) able to take a stack of confinement boxes (10), the tray being mobile in a direction perpendicular to transfer direction (X), so that it can position confinement boxes successively in front of coupling means (30).
